# EUROPEAN PATENT SPECIFICATION

(11) **EP 3 770 619 B1**
(45) Date of publication and mention of the grant of the patent: **25.10.2023**
(21) Application number: 19770833.2
(22) Date of filing: 14.03.2019
(51) Int. Cl.: G01R 31/392, G01R 31/367, H01M 10/42, H01M 10/48, H02J 7/00

(54) **DEGRADATION ESTIMATING DEVICE AND DEGRADATION ESTIMATING METHOD**
VERSCHLECHTERUNGSSCHÄTZUNGSVORRICHTUNG UND VERSCHLECHTERUNGSSCHÄTZUNGSVERFAHREN
DISPOSITIF D'ESTIMATION DE DÉGRADATION ET PROCÉDÉ D'ESTIMATION DE DÉGRADATION

(30) Priority: 20.03.2018 JP 2018053016
(43) Date of publication of application: 27.01.2021
(73) Proprietor: GS Yuasa International Ltd., Kisshoin, Minami-ku, Kyoto-shi, Kyoto 601-8520 (JP)
(72) Inventor: UKUMORI, Nan, Kyoto-shi, Kyoto 601-8520 (JP)
(74) Representative: Grünecker Patent- und Rechtsanwälte PartG mbB
(86) International application number: PCT/JP2019/010543
(87) International publication number: WO 2019/181728

(56) References cited:
- WO-A1-2016/092811
- WO-A1-2016/208251
- WO-A1-2017/002292
- JP-A- H09 243 716
- JP-A- 2001 325 582
- JP-A- 2006 220 616
- JP-A- 2016 223 964
- US-A1- 2017 205 469
- US-B2- 7 554 296
- LIN XUE ET AL: "Machine learning-based energy management in a hybrid electric vehicle to minimize total operating cost", 2015 IEEE/ACM INTERNATIONAL CONFERENCE ON COMPUTER-AIDED DESIGN (ICCAD), IEEE, 2 November 2015 (2015-11-02), pages 627-634, XP032845825, DOI: 10.1109/ICCAD.2015.7372628 [retrieved on 2016-01-05]

## Description

### TECHNICAL FIELD

The present invention relates to a degradation estimation apparatus, a computer program, and a degradation estimating method.

### BACKGROUND ART

An energy storage device has been widely used in an uninterruptible power supply, a DC or AC power supply included in a stabilized power supply, and the like. In addition, the use of energy storage devices in large-scale systems that store renewable energy or electric power generated by existing power generating systems is expanding.

An energy storage module has a configuration in which energy storage cells are connected in series. It is known that degradation of an energy storage cell progresses by repeating charge and discharge. Patent Document 1 discloses a technique of detecting a state of charge (SOC) of a secondary battery for a vehicle by inputting a battery voltage detected by a temperature sensor to a neural network unit having learned from the necessity of capacity management and safety management.

### PRIOR ART DOCUMENT

### PATENT DOCUMENT

Patent Document 1: JP-A-2008-232758

WO2016208251 A1 describes improving the prediction accuracy of battery deterioration. An energy storage system includes a storage cell; a battery usage history detection unit that detects a usage history of the storage cell; an operation mode classification unit that classifies an operation mode of the storage cell according to the usage history of the storage cell; an SOH estimation unit that estimates a deterioration index value of the storage cell according to the usage history of the storage cell; and a remaining-service-life estimation unit that calculates a remaining service life of the storage cell according to the usage history of the operation mode of the storage cell, and the deterioration index value of the storage cell. The usage history of the storage cell represents a current value of the storage cell, a battery temperature of the storage cell, and a battery voltage of the storage cell.
US2017205469 A describes an apparatus and method for estimating a state of a battery is provided. According to one aspect, a battery state estimation apparatus includes a state of health (SOH) estimator configured to estimate SOH of a battery based on degradation of the battery and the data acquired from the battery, and a state of charge (SOC) estimator configured to estimate the SOC of the battery based on the SOH of the battery.
LIN XUE ET AL., "Machine learning-based energy management in a hybrid electric vehicle to minimize total operating cost" describes the energy management problem in hybrid electric vehicles (HEVs) focusing on the minimization of the operating cost of an HEV, including both fuel and battery replacement cost.
US7554296 A describes a neural network type of apparatus is provided to detect an internal state of a secondary battery implemented in a battery system. The apparatus comprises a detecting unit, producing unit and estimating unit. The detecting unit detects electric signals indicating an operating state of the battery. The producing unit produces, using the electric signals, an input parameter required for estimating the internal state of the battery. The input parameter reflects calibration of a present charged state of the battery which is attributable to at least one of a present degraded state of the battery and a difference in types of the battery. The estimating unit estimates an output parameter indicating the charged state of the battery by applying the input parameter to neural network calculation.

### SUMMARY OF THE INVENTION

The invention is defined by the appended independent claims.

Examples mentioned in the following description that do not necessarily fall under the scope of the appended claims are to be construed as comparative examples useful for understanding the present invention

### PROBLEMS TO BE SOLVED BY THE INVENTION

For the calculation of the SOC, for example, a method such as a current integration method is used. It is possible to calculate the SOC with relatively short time current data. Therefore, data for learning for causing the neural network unit to learn can be collected easily. However, a change in the state of health (SOH) of the energy storage device takes more time than a change in the SOC, so that it is not easy to estimate the SOH.

An object of the present invention is to provide a degradation estimation apparatus, and a degradation estimation method for estimating degradation of an energy storage device by using Artificial Intelligence (Al).

### MEANS FOR SOLVING THE PROBLEMS

A degradation estimation apparatus for estimating degradation of an energy storage device includes: a SOH acquisition unit that acquires a SOH of an energy storage device at a first time point and a SOH at a second time point after the first time point; a representative value acquisition unit that acquires a SOC representative value of the energy storage device from the first time point to the second time point; and a learning processing unit that causes a learning model to learn based on learning data with the SOH at the first time point and the representative value as input data and with the SOH at the second time point as output data.

A degradation estimation method for estimating degradation of an energy storage device includes: acquiring a SOH of an energy storage device at a first time point and a SOH at a second time point after the first time point; acquiring a SOC representative value of the energy storage device from the first time point to the second time point; and causing a learning model to learn based on learning data with the SOH at the first time point and the representative value as input data and with the SOH at the second time point as output data.

The SOH acquisition unit acquires the SOH of the energy storage device at the first time point and the SOH at the second time point after the first time point. The energy storage device may be, for example, an energy storage device operating in a mobile body or a facility. Sensor information (e.g., current, voltage, and temperature) can be collected from the energy storage device by using a monitoring apparatus or the like. The SOH can be estimated by a known method based on the sensor information. Alternatively, the SOH may be estimated using a method described in Japanese Patent Application No. 2017-065532 (its entire contents are incorporated herein by reference). The period between the first time point and the second time point can be appropriately set and may be, for example, one month or three months. When the sensor information has periodicity, the period between the first time point and the second time point may be divided by the cycle of the sensor information. At that time, an interpolation value at the first and second time points may be used for the SOH.

The representative value acquisition unit acquires a SOC representative value of the energy storage device from the first time point to the second time point. In a lithium ion battery, a solid electrolyte interface layer (SEI layer) is generated at an interface between an electrode and an electrolyte solution by charging and discharging or standing, and the SOH decreases as the SEI layer grows. Based on the hypothesis that the growth of the SEI layer depends on the SOC, the present inventors have proposed to acquire a SOC representative value that affects a decrease in the SOH of the energy storage device and use the representative value for AI learning. The SOC representative value can be said to be information that abstracts the detailed behavior of the energy storage device in operation.

The learning processing unit causes a learning model to learn based on learning data with the SOH at the first time point and the representative value as input data and with the SOH at the second time point as output data. For example, the SOH at the first time point is represented by SOH(N), and the SOH at the second time point is represented by SOH(N+1). The learning model learns that the SOH at the first time point is SOH(N), and the SOH at the second time point is SOH(N+1) in accordance with a SOC representative value of the energy storage device from the first time point to the second time point.

Such learning data includes the SOH at the first time point, the SOH at the second time point, and the SOC representative value between the first time point and the second time point. The SOC representative value can be said to be a statistic obtained by abstracting or processing information for causing the learning model to learn. Thus, the learning model can be caused to learn with a relatively small amount of information, and a large amount of data of the energy storage device is not required.

When a SOH at a certain time point (e.g., at present) and a SOC representative value from the time point to a prediction target point are input to a learning-completed learning model, a SOH at the prediction target point can be estimated. Thereby, the degradation of the energy storage device can be estimated using the AI.

A degradation estimation apparatus for estimating degradation of an energy storage device includes: a SOH acquisition unit that acquires a SOH of an energy storage device at a first time point; a representative value acquisition unit that acquires a SOC representative value of the energy storage device from the first time point to the second time point; and a learning-completed learning model that uses the SOH at the first time point and the representative value are input data to estimate SOH at the second time point.

A degradation estimation method for estimating degradation of an energy storage device includes: acquiring a SOH of an energy storage device at a first time point; acquiring a SOC representative value of the energy storage device from the first time point to the second time point; and estimating the SOH at the second time point by inputting the SOH at the first time point and the representative value to the learning-completed learning model.

The SOH acquisition unit acquires the SOH of the energy storage device at the first time point. Sensor information (e.g., current, voltage, and temperature) can be collected from the energy storage device by using a monitoring apparatus or the like. The SOH can be estimated by a known method based on the sensor information. Alternatively, the SOH may be estimated using a method described in Japanese Patent Application No. 2017-065532 (its entire contents are incorporated herein by reference). As the SOH at the first time point, a value estimated by a learning-completed learning model based on the SOH at a time point before the first time point can also be used. Thus, the SOH can be continuously estimated in any period.

The representative value acquisition unit acquires a SOC representative value of the energy storage device from the first time point to the second time point. The second time point is a prediction target point at which the SOH is estimated. The SOC representative value of the energy storage device can be obtained by abstracting the detailed behavior of the energy storage device in operation from the first time point to the second time point.

The learning-completed learning model estimates the SOH at the second time point with the representative values of the SOH and the SOC at the first time point as input data. Thus, when the SOH at the first time point (e.g., at present) and the SOC representative value of the energy storage device from the first time point to the second time point (prediction target point) are known, the SOH at the second time point can be estimated. It can also be determined how to set the SOC representative value of the energy storage device from the first time point to the second time point to make the SOH at the second time point larger (prevent a decrease in the SOH).

The degradation estimation apparatus may include a SOC estimation unit that estimates a SOC transition of the energy storage device from the first time point to the second time point, and the representative value acquisition unit may acquire at least any one of a total SOC variation amount and a SOC variation range from the first time point to the second time point based on the SOC transition.

The SOC estimation unit estimates a SOC transition of the energy storage device from the first time point to the second time point. For example, in a case where the amount of data in the time series of the SOC of the energy storage device from the first time point to the second time point is not sufficient, and there exists a time or time zone in which the value of the SOC is unknown, a SOC transition pattern can be estimated by interpolating a SOC value at a place where data exists based on the obtained data of the SOC. This eliminates the need for a large amount of sensor information.

The representative value acquisition unit acquires a SOC average from the first time point to the second time point based on the SOC transition. The SOC average is a value obtained by dividing a value, obtained by sampling and summing SOC values from the first time point to the second time point, by the number of samples, and the SOC average is a central SOC. When the SOC of the energy storage device varies, the degree of decrease in SOH differs depending on the SOC average. Therefore, by causing the learning model to learn the SOC average from the first time point to the second time point, it is possible to generate a learning-completed learning model that can accurately estimate a SOH.

The representative value acquisition unit acquires the total SOC variation amount from the first time point to the second time point based on the SOC transition. The total SOC variation amount is the integration of variation amounts along a route of how the SOC has varied from the first time point to the second time point. When the SOC of the energy storage device varies, the degree of decrease in SOH differs depending on the total SOC variation amount. Therefore, by causing the learning model to learn the total SOC variation amount from the first time point to the second time point, it is possible to generate a learning-completed learning model that can accurately estimate a SOH.

The representative value acquisition unit acquires the SOC variation range from the first time point to the second time point based on the SOC transition. The SOC variation range is a difference between the maximum value and the minimum value of the SOC from the first time point to the second time point. When the SOC of the energy storage device varies, the degree of decrease in SOH differs depending on the SOC variation range. Therefore, by causing the learning model to learn the SOC variation range from the first time point to the second time point, it is possible to generate a learning-completed learning model that can accurately estimate a SOH.

The degradation estimation apparatus includes a SOC estimation unit that estimates a SOC transition of the energy storage device from the first time point to the second time point, and the representative value acquisition unit may acquire the SOC transition as the representative value.

The SOC estimation unit estimates a SOC transition of the energy storage device from the first time point to the second time point. For example, in a case where the amount of data in the time series of the SOC of the energy storage device from the first time point to the second time point is not sufficient, and there exists a time or time zone in which the value of the SOC is unknown, a SOC transition pattern can be estimated by interpolating a SOC value at a place where data exists based on the obtained data of the SOC. This eliminates the need for a large amount of sensor information.

The representative value acquisition unit acquires a SOC transition as a representative value. The degree of decrease in SOH differs depending on the SOC transition pattern from the first time point to the second time point. Therefore, by causing the learning model to learn the SOC transition pattern from the first time point to the second time point, it is possible to generate a learning-completed learning model that can accurately estimate a SOH.

The degradation estimation apparatus includes a temperature acquisition unit that acquires a temperature transition of the energy storage device from the first time point to the second time point, and the learning processing unit may cause a learning model to learn based on learning data with the temperature transition as additional input data.

The temperature acquisition unit acquires a temperature transition of the energy storage device from the first time point to the second time point. The temperature transition to be acquired may be a measured value or an estimated value. For example, in a case where the amount of data in the time series of the temperature of the energy storage device from the first time point to the second time point is not sufficient, and there exists a time or time zone in which the value of the temperature is unknown, a temperature transition pattern can be estimated by interpolating a temperature value at a place where data exists based on the obtained data of the temperature. This eliminates the need for a large amount of sensor information.

The learning processing unit causes a learning model to learn based on learning data with the temperature transition as input data. The degree of decrease in SOH differs depending on the temperature transition pattern from the first time point to the second time point. Therefore, by causing the learning model to learn the temperature transition pattern from the first time point to the second time point, it is possible to generate a learning-completed learning model that can accurately estimate a SOH.

In the degradation estimation apparatus, the temperature acquisition unit may acquire a temperature representative value of the energy storage device from the first time point to the second time point, and the learning processing unit may cause a learning model to learn based on learning data with the temperature representative value as additional input data.

The temperature representative value can be said to be a statistic obtained by abstracting or processing information for causing the learning model to learn. The learning processing unit causes a learning model to learn based on learning data with the temperature representative value as input data. The degree of decrease in SOH differs depending on the temperature representative value from the first time point to the second time point. Therefore, by causing the learning model to learn the temperature representative value from the first time point to the second time point, it is possible to generate a learning-completed learning model that can accurately estimate a SOH.

In the degradation estimation apparatus, the learning processing unit may cause a learning model to learn based on learning data with an elapsed period from a point of manufacturing the energy storage device to the first time point as additional input data.

The learning processing unit causes a learning model to learn based on learning data with an elapsed period from the point of manufacturing the energy storage device to the first time point as additional input data. The SOH of the energy storage device decreases with the standing time (calendar degradation). The decrease in SOH after the first time point is considered to depend on the length of time elapsed from the point of manufacturing (e.g., the point of completion of manufacturing) to the first time point. Therefore, by further generating learning data with the elapsed period from the point of manufacturing the energy storage device to the first time point as input data, it is possible to generate a learning-completed learning model that can accurately estimate the SOH.

In the degradation estimation apparatus, the learning processing unit may cause a learning model to learn based on learning data with a cycle number of charge and discharge from the point of manufacturing the energy storage device to the first time point as additional input data.

The learning processing unit causes a learning model to learn based on learning data with a total amount of energized electricity (e.g., a cycle number of charge and discharge when the cycle number can be specified) from the point of manufacturing the energy storage device to the first time point as input data. The SOH of the energy storage device decreases with the cycle number of charge and discharge (cycle degradation). The decrease in SOH after the first time point is considered to depend somewhat on the cycle number of charge and discharge from the point of manufacturing (e.g., the point of completion of manufacturing) to the first time point.

Therefore, when it is possible to specify the cycle number of charge and discharge, by further generating learning data with the cycle number of charge and discharge from the point of manufacturing the energy storage device to the first time point as input data, it is possible to generate a learning-completed learning model that can accurately estimate the SOH. When it is not possible to specify the cycle number of charge and discharge, the total amount of energized electricity may be used instead of the cycle number of charge and discharge.

In the degradation estimation apparatus, the learning processing unit may provide a plurality of learning periods from the first time point to the second time point over a use period of the energy storage device to cause a learning model to learn based on learning data.

The learning processing unit provides a plurality of learning periods from the first time point to the second time point over a use period of the energy storage device to cause a learning model to learn based on learning data. Assuming that the learning period from the first time point to the second time point is ΔN, it is possible to estimate a SOH at a required time point after the manufacturing of the energy storage device to reach the life by causing a learning model to learn using data for learning for each of the plurality of learning periods ΔN over the use period from the point of manufacturing to the life of the energy storage device, for example.

The degradation estimation apparatus estimates the degradation of the energy storage device by using a learning-completed learning model caused to learn by the learning processing unit. Thus, when the SOH at the first time point (e.g., at present) and the SOC representative value of the energy storage device from the first time point to the second time point (prediction target point) are known, the SOH at the second time point can be estimated. It can also be determined how to set the SOC representative value of the energy storage device from the first time point to the second time point to make the SOH at the second time point larger (prevent a decrease in the SOH).

A degradation estimation apparatus for estimating degradation of an energy storage device includes: an output value acquisition unit that inputs a SOC representative value to a degradation simulator configured to estimate a SOH of the energy storage device based on variation in a SOC of the energy storage device, and acquires a SOH output by the degradation simulator; an input value acquisition unit that acquires the SOC representative value, input to the degradation simulator; a learning processing unit that uses the SOC representative value acquired by the input value acquisition unit and the SOH acquired by the output value acquisition unit as learning data to cause a learning model to learn; a representative value acquisition unit that acquires a SOC representative value of the energy storage device; a SOH acquisition unit that acquires a SOH of the energy storage device; and a relearning processing unit that uses the SOC representative value acquired by the representative value acquisition unit and the SOH acquired by the SOH acquisition unit as learning data to cause relearning of the learning model caused to learn by the learning processing unit.

A degradation estimation method for estimating degradation of an energy storage device includes: inputting a SOC representative value to a degradation simulator configured to estimate a SOH of the energy storage device based on variation in a SOC of the energy storage device, and acquiring a SOH output by the degradation simulator; acquiring the SOC representative value, input to the degradation simulator; using the acquired SOC representative value and the acquired SOH as learning data to cause a learning model to learn; acquiring a SOC representative value of the energy storage device; acquiring a SOH of the energy storage device; and using the acquired SOC representative value and the acquired SOH as learning data to cause relearning of the learning model caused to learn by the learning processing unit.

The output value acquisition unit inputs a SOC representative value to a degradation simulator configured to estimate a SOH of the energy storage device based on variation in a SOC of the energy storage device, and acquiring a SOH output by the degradation simulator.

The degradation simulator can estimate a degradation value of the SOH of the energy storage device on the basis of the SOC transition based on the SOC representative value and of the temperature of the energy storage device. A degradation value Qdeg after the lapse of the degradation prediction target period (e.g., from time point t to time point t+1) of the energy storage device can be calculated by a formula Qdeg = Qcnd + Qcur. Here, Qcnd is a non-energization degradation value and Qcur is an energization degradation value. The non-energization degradation value Qcnd can be obtained by, for example, Qcnd = K1 × √(t). Here, a coefficient K1 is a function of a SOC and a temperature T. "t" is an elapsed time, for example, the time from time point t to time point t+1. The energization degradation value Qcur can be obtained by, for example, Qcur = K2 × √(t). Here, the coefficient K2 is a function of the SOC and the temperature T. Assuming that the SOH at time point t is SOHₜ and the SOH at time point t+1 is SOHₜ₊₁, the SOH can be estimated by SOHₜ₊₁ = SOHₜ - Qdeg. The coefficient K1 is a degradation coefficient, and the correspondence relation between each of the SOC and the temperature T and the coefficient K1 may be obtained by calculation or stored in a table form. Here, the SOC may be a representative value, such as the central SOC or the SOC variation range. A coefficient K2 is the same as the coefficient K1.

The input value acquisition unit acquires a SOC representative value input to the degradation simulator.

The learning processing unit uses the SOC representative value acquired by the input value acquisition unit and the SOH acquired by the output value acquisition unit as learning data to cause a learning model to learn When SOC representative values of various patterns are input to the degradation simulator, the degradation simulator outputs a degradation value (i.e., SOH) with high accuracy with respect to the input SOC representative values. Various SOC representative values can be relatively easily generated for simulation, thereby facilitating the generation of data for learning of a learning model and the improvement in the estimation accuracy (percentage of correct answers) of the learning model.

The representative value acquisition unit acquires a SOC representative value of the energy storage device. The SOC representative value can be said to be information that abstracts the detailed behavior of the energy storage device in operation, can be obtained from the SOC transition obtained from the sensor information, and includes, for example, the SOC average, the total SOC variation amount, the SOC variation range, and the like. Note that the SOC representative value can be obtained based on the measured value of the SOC transition, but a calculated value may be used in addition to the measured value.

The SOH acquisition unit acquires the SOH of the energy storage device. Sensor information (e.g., current, voltage, and temperature) can be collected from the energy storage device. The SOH can be estimated by a known method based on the sensor information. Alternatively, the SOH may be estimated using a method described in Japanese Patent Application No. 2017-065532 (its entire contents are incorporated herein by reference).

The relearning processing unit uses the SOC representative value acquired by the representative value acquisition unit and the SOH acquired by the SOH acquisition unit as learning data to cause a learning model, caused to learn by the learning processing unit, to learn. The SOC representative value or the SOH obtained by collecting sensor information, for example, tends to require a large amount of data for learning in order to enhance the estimation accuracy (percentage of correct answers) of the learning model when the pattern of transition becomes complicated and learning model not having learned is caused to learn using these pieces of data as data for learning. By using the degradation simulator in advance, the learning data can be obtained relatively easily, and the estimation accuracy of the learning model not having learned can be enhanced. Therefore, by relearning processing, the accuracy of the learning model can be further enhanced even without a large amount of data for learning, and the accuracy of the degradation estimation of the energy storage device can be enhanced.

In the degradation estimation apparatus, the SOH acquisition unit acquires the SOH of the energy storage device at a first time point and the SOH at a second time point after the first time point, and the representative value acquisition unit acquires the SOC representative value of the energy storage device from the first time point to the second time point.

The SOH acquisition unit acquires the SOH of the energy storage device at the first time point and the SOH at the second time point after the first time point. The energy storage device may be, for example, an energy storage device operating in a mobile body or a facility. Sensor information (e.g., current, voltage, and temperature) can be collected from the energy storage device by using a monitoring apparatus or the like. The SOH can be estimated by a known method based on the sensor information. Alternatively, the SOH may be estimated using a method described in Japanese Patent Application No. 2017-065532 (its entire contents are incorporated herein by reference). The period between the first time point and the second time point can be appropriately set and may be, for example, one month or three months. When the sensor information has periodicity, the period between the first time point and the second time point may be divided by the cycle of the sensor information. At that time, an interpolation value at the first and second time points may be used for the SOH.

The representative value acquisition unit acquires a SOC representative value of the energy storage device from the first time point to the second time point. In a lithium ion battery, a solid electrolyte interface layer (SEI layer) is generated at an interface between an electrode and an electrolyte solution by charging and discharging or standing, and the SOH decreases as the SEI layer grows. Based on the hypothesis that the growth of the SEI layer depends on the SOC, the present inventors have proposed to acquire a SOC representative value that affects a decrease in the SOH of the energy storage device and use the representative value for AI learning. The SOC representative value can be said to be information that abstracts the detailed behavior of the energy storage device in operation and includes, for example, the SOC average, the total SOC variation amount, and the SOC variation range.

The relearning processing unit causes a learning-completed learning model, caused to learn by the learning processing unit, to relearn based on learning data with the SOH at the first time point and the representative value as input data and with the SOH at the second time point as output data. For example, the SOH at the first time point is represented by SOH(N), and the SOH at the second time point is represented by SOH(N+1). The learning model relearns that the SOH at the first time point is SOH(N), and the SOH at the second time point is SOH(N+1) in accordance with a SOC representative value of the energy storage device from the first time point to the second time point.

Such learning data includes the SOH at the first time point, the SOH at the second time point, and the SOC representative value between the first time point and the second time point. The SOC representative value can be said to be a statistic obtained by abstracting or processing information for causing the learning-completed learning model to relearn. Thus, the learning-completed learning model can be relearned with a relatively small amount of information, and a large amount of data of the energy storage device is not required.

When a SOH at a certain time point (e.g., at present) and a SOC representative value from the time point to a prediction target point are input to a learning-completed or relearning-completed learning model, a SOH at the prediction target point can be estimated. Thereby, the degradation of the energy storage device can be estimated using the AI.

A degradation estimation apparatus for estimating degradation of an energy storage device includes a learning model caused to learn using as learning data a SOC representative value to be input to a degradation simulator configured to estimate a SOH of the energy storage device based on variation in the SOC of the energy storage device and a SOH output by the degradation simulator when the SOC representative value is input to the degradation simulator. The learning model is further caused to relearn the SOC representative value of the energy storage device and the SOH of the energy storage device as learning data. The apparatus includes: a SOH acquisition unit that acquires a SOH of the energy storage device at a first time point; and a representative value acquisition unit that acquires a SOC representative value of the energy storage device from the first time point to the second time point. The SOH at the first time point and the representative value acquired by the representative value acquisition unit are input to the learning model to estimate the SOH at the second time point.

In a degradation estimation method for estimating degradation of an energy storage device includes: acquiring a SOH of an energy storage device at a first time point; acquiring a SOC representative value of the energy storage device from the first time point to the second time point; and estimating the SOH at the second time point by inputting the SOH at the first time point and the representative value to a learning model. The leaning model is caused to learn using as learning data: a SOC representative value to be input to a degradation simulator configured to estimate a SOH of the energy storage device based on variation in the SOC of the energy storage device; and the SOH output by the degradation simulator when the SOC representative value is input to the degradation simulator. The learning model is further caused to relearn the SOC representative value of the energy storage device and the SOH of the energy storage device as learning data.

The learning model has been caused to learn using as learning data a SOC representative value to be input to a degradation simulator configured to estimate the SOH of the energy storage device based on variation in the SOC of the energy storage device and the SOH output by the degradation simulator when the SOC representative value is input to the degradation simulator. The learning model has further caused to relearn using the SOC representative value of the energy storage device and the SOH of the energy storage device as learning data.

By using the degradation simulator in advance, the learning data can be obtained relatively easily, and the estimation accuracy of the learning model not having learned can be enhanced. Further, by relearning, the accuracy of the learning model can be further enhanced even without a large amount of data for learning, and the accuracy of the degradation estimation of the energy storage device can be enhanced.

The SOH acquisition unit acquires the SOH of the energy storage device at the first time point. The representative value acquisition unit acquires a SOC representative value of the energy storage device from the first time point to the second time point. The SOH at the first time point and the representative value acquired by the representative value acquisition unit are input to the learning model to estimate the SOH at the second time point.

When a SOH at a certain time point (e.g., at present) and a SOC representative value from the time point to a prediction target point are input to a learning-completed or relearning-completed learning model, a SOH at the prediction target point can be estimated. Thereby, the degradation of the energy storage device can be estimated using the AI.

### BRIEF DESCRIPTION OF THE DRAWINGS

Fig. 1 is a diagram showing an outline of a remote monitoring system of the present embodiment.
Fig. 2 is a block diagram showing an example of the configuration of the remote monitoring system.
Fig. 3 is a diagram showing an example of a connection mode of a communication device.
Fig. 4 is a block diagram showing an example of a configuration of a server apparatus.
Fig. 5 is a schematic diagram showing an example of a configuration of a learning model.
Fig. 6 is a schematic diagram showing an example of a decrease in SOH in accordance with the use time of the energy storage device.
Fig. 7 is a schematic diagram showing an example of the relationship between the temperature and the decrease in SOH in a standing test in a constant SOC.
Fig. 8 is a schematic diagram showing an example of the relationship between the SOC average and the decrease in SOH in a standing test at a constant temperature.
Fig. 9 is a schematic diagram showing an example of the relationship between the SOC variation range and the decrease in SOH in a cycle test at a constant temperature and a constant SOC average.
Fig. 10 is a schematic diagram showing an example of the relationship between the total SOC variation amount and the decrease in SOH in a cycle test at a constant temperature and a constant SOC variation range.
Fig. 11 is a schematic diagram showing an example of a decrease in SOH of the energy storage device at each of the first and second time points.
Fig. 12 is a schematic diagram showing an example of temperature data from the first time point to the second time point.
Fig. 13 is a schematic diagram showing an example of a SOC transition pattern from the first time point to the second time point.
Fig. 14 is a schematic diagram showing an example of a SOC representative value between the first time point and the second time point.
Fig. 15 is a block diagram showing an example of data for learning.
Fig. 16 is a block diagram showing another example of the data for learning.
Fig. 17 is a schematic diagram showing an example in which a plurality of learning periods are set.
Fig. 18 is a block diagram showing an example of input data for life estimation.
Fig. 19 is a block diagram showing another example of the input data for life estimation.
Fig. 20 is a schematic diagram showing an example of a degradation estimation result of the energy storage device.
Fig. 21 is a flowchart showing an example of a processing procedure of a processing unit in a learning mode.
Fig. 22 is a flowchart showing an example of a processing procedure of the processing unit in an estimation mode.
Fig. 23 is a schematic diagram showing an example of a SOC transition pattern of the energy storage device from the first time point to the second time point.
Fig. 24 is a schematic diagram showing an example of a temperature transition pattern of the energy storage device from the first time point to the second time point.
Fig. 25 is a schematic diagram showing an operation of a degradation simulator according to a third embodiment.
Fig. 26 is a schematic diagram showing an example of SOH estimation by using the degradation simulator.
Fig. 27 is a block diagram showing an example of data for learning based on an estimated value of the degradation simulator.
Fig. 28 is a schematic diagram showing an example of the relationship between the learning data set of the learning model and the estimation accuracy.
Fig. 29 is a flowchart showing an example of a processing procedure of a processing unit in a learning mode according to the third embodiment.

### MODE FOR CARRYING OUT THE INVENTION

### (First embodiment)

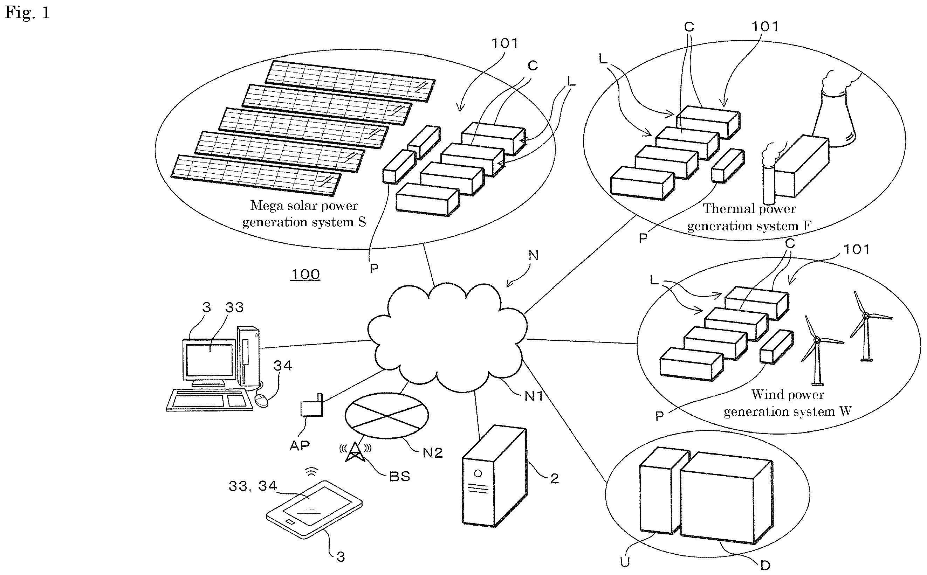

Hereinafter, a degradation estimation apparatus according to the present embodiment will be described with reference to the drawings. Fig. 1 is a diagram showing an outline of a remote monitoring system 100 of the present embodiment. As shown in Fig. 1, a thermal power generation system F, a mega solar power generation system S, a wind power generation system W, a uninterruptible power supply (UPS) U, a rectifier (d.c. power supply or a.c. power supply) D disposed in a stabilized power supply system for railways, and the like are connected to a network N including a public communication network (e.g., the Internet) N1, a carrier network N2 that achieves wireless communication based on a mobile communication standard, and the like. A communication device 1 to be described later, a server apparatus 2 that collects information from the communication device 1 and serves as a degradation estimation apparatus, and a client apparatus 3 that acquires the collected information are connected to the network N. In the present embodiment, the degradation estimation apparatus may be a life simulator.

More specifically, the carrier network N2 includes a base station BS, and the client apparatus 3 can communicate with the server apparatus 2 from the base station BS via the network N. An access point AP is connected to the public communication network N1, and the client apparatus 3 can transmit and receive information to and from the server apparatus 2 via the network N from the access point AP.

A power conditioner (power conditioning system: PCS) P and an energy storage system 101 are attached to a mega solar power generation system S, a thermal power generation system F and a wind power generation system W. The energy storage system 101 is configured by juxtaposing a plurality of containers C each housing an energy storage module group L. The energy storage module group L has a hierarchical structure of, for example, an energy storage module (also called a module) in which a plurality of energy storage cells (also called a cell) are connected in series, a bank in which a plurality of energy storage modules are connected in series, and a domain in which a plurality of banks are connected in parallel. The energy storage device is preferably rechargeable, such as a secondary battery like a lead-acid battery or a lithium ion battery, or a capacitor. Apart of the energy storage device may be a primary battery that is not rechargeable.

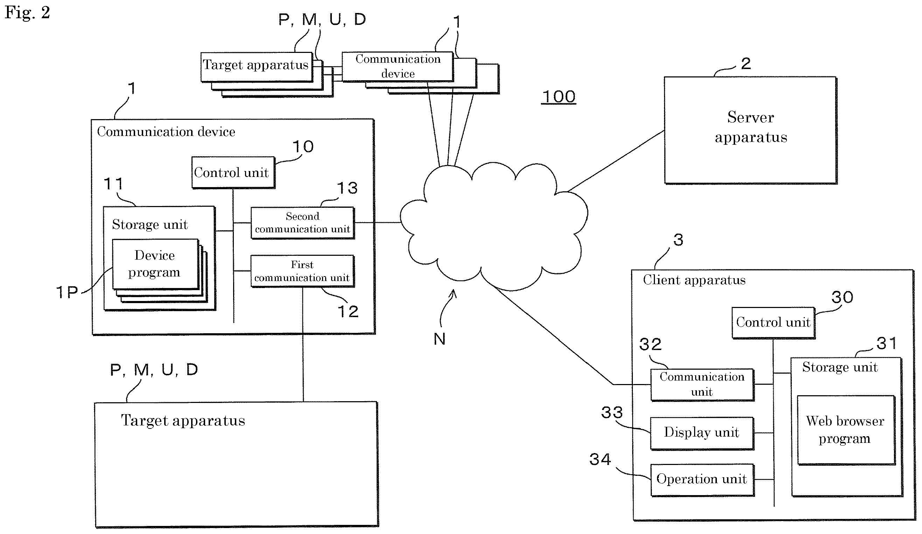

Fig. 2 is a block diagram showing an example of the configuration of the remote monitoring system 100. The remote monitoring system 100 includes the communication device 1, a server apparatus 2, a client apparatus 3, and the like.

As shown in Fig. 2, the communication device 1 is connected to the network N and is also connected to the target apparatuses P, U, D, M. The target apparatuses P, U, D, M include a power conditioner P, an uninterruptible power supply U, a rectifier D, and a management apparatus M to be described later.

In the remote monitoring system 100, the state (e.g., voltage, current, temperature, state of charge (SOC)) of the energy storage module (energy storage cell) in the energy storage system 101 is monitored and collected by using the communication device 1 connected to each of the target apparatuses P, U, D, M. The remote monitoring system 100 presents the detected state (including a degraded state, an abnormal state, etc.) of the energy storage cell so that a user or an operator (a person in charge of maintenance) can confirm the detected state.

The communication device 1 includes a control unit 10, a storage unit 11, a first communication unit 12, and a second communication unit 13. The control unit 10 is made of a central processing unit (CPU) or the like, and controls the entire communication device 1 by using built-in memories such as read-only memory (ROM) and random-access memory (RAM).

The storage unit 11 may be a nonvolatile memory such as a flash memory. The storage unit 11 stores a device program 1P to be read and executed by the control unit 10. The storage unit 11 stores information such as information collected by the processing of the control unit 10 and event logs.

The first communication unit 12 is a communication interface for achieving communication with the target apparatuses P, U, D, M and can use, for example, a serial communication interface such as RS-232 C or RS-485.

The second communication unit 13 is an interface for achieving communication via the network N and uses, for example, a communication interface such as an Ethernet (registered trademark) or a wireless communication antenna. The control unit 10 can communicate with the server apparatus 2 via the second communication unit 13.

The client apparatus 3 may be a computer used by the operator such as a manager of the energy storage system 101 of the power generation systems S, F or a person in charge of maintenance of the target apparatuses P, U, D, M. The client apparatus 3 may be a desktop type or a laptop type personal computer or may be a smartphone or a tablet type communication terminal. The client apparatus 3 includes a control unit 30, a storage unit 31, a communication unit 32, a display unit 33, and an operation unit 34.

The control unit 30 is a processor using a CPU. A control unit 30 causes a display unit 33 to display a Web page provided by the server apparatus 2 or the communication device 1 based on a Web browser program stored in a storage unit 31.

The storage unit 31 uses a nonvolatile memory such as a hard disk or a flash memory. The storage unit 31 stores various programs including a Web browser program.

The communication unit 32 can use a communication device such as a network card for wired communication, a wireless communication device for mobile communication connected to a base station BS (see Figure 1), or a wireless communication device corresponding to connection to the access point AP. The control unit 30 enables communication connection or transmission and reception of information between the server apparatus 2 or the communication device 1 via the network N by the communication unit 32

The display unit 33 may be a liquid crystal display, an organic electroluminescence (EL) display, or the like. The display unit 33 can display an image of a Web page provided by the server apparatus 2 by processing based on the Web browser program of the control unit 30.

The operation unit 34 is a user interface, such as a keyboard and a pointing device, capable of input and output with the control unit 30 or a voice input unit. A touch panel of the display unit 33 or a physical button provided in the housing may be used for the operation unit 34. The operation unit 34 notifies information of operation by the user to the control unit 20.

The configuration of the server apparatus 2 will be described later.

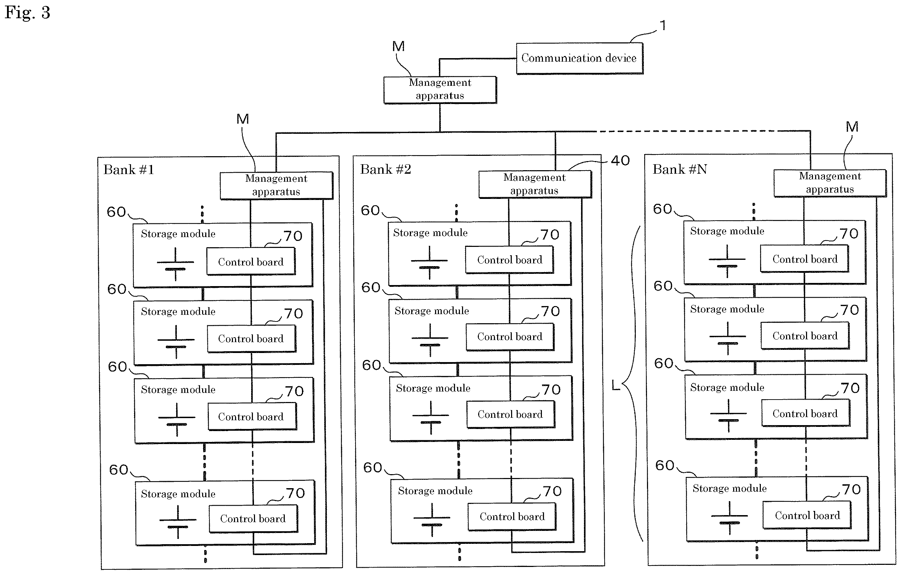

Fig. 3 is a diagram showing an example of the connection mode of the communication device 1. As shown in Fig. 3, the communication device 1 is connected to the management apparatus M. Management apparatuses M provided in banks # 1 to # N, respectively, are connected to the management apparatus M. Note that the communication device 1 may be a terminal apparatus (measurement monitor) that communicates with the management apparatuses M provided in each of the banks # 1 to # N to receive information on the energy storage devices, or may be a network card type communication device that can be connected to a power-supply-related apparatus.

Each of the banks # 1 to # N includes a plurality of energy storage modules 60, and each energy storage module 60 comprises a control board (cell monitoring unit: CMU) 70. The management apparatus M provided for each bank can communicate with the control board 70 with a communication function built in each energy storage module 60 by serial communication and can transmit and receive information to and from the management apparatus M connected to a communication device 1. The management apparatus M connected to the communication device 1 aggregates information from each management apparatus M of the bank belonging to a domain and outputs the aggregated information to the communication device 1.

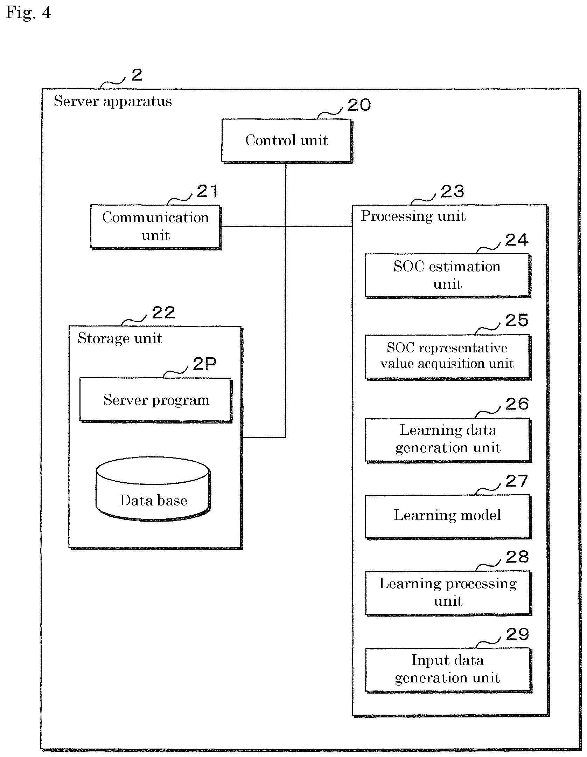

Fig. 4 is a block diagram showing an example of the configuration of the server apparatus 2. The server apparatus 2 includes a control unit 20, a communication unit 21, a storage unit 22, and a processing unit 23. The processing unit 23 includes a SOC estimation unit 24, a SOC representative value acquisition unit 25, a learning data generation unit 26, a learning model 27, a learning processing unit 28, and an input data generation unit 29. The server apparatus 2 may be a single server computer, but is not limited to this, and may be made up of a plurality of server computers. Note that the server apparatus 2 may be a simulator.

The control unit 20 can be made of, for example, a CPU, and controls the entire server apparatus 2 by using built-in memories such as ROM and RAM. The control unit 20 executes information processing based on a server program 2P stored in the storage unit 22. The server program 2P includes a Web server program, and the control unit 20 functions as a Web server that performs provision of a Web page to the client apparatus 3, reception of a login to a Web service, and the like. The control unit 20 can also collect information from the communication device 1 as a simple network management protocol) (SNMP) server based on the server program 2P.

The communication unit 21 is a communication device that achieves the communication connection and the transmission and reception of data via the network N. Specifically, the communication unit 21 is a network card corresponding to the network N.

The storage unit 22 may be a nonvolatile memory such as a hard disk or a flash memory. The storage unit 22 stores sensor information (e.g., voltage data, current data, and temperature data of the energy storage device) that includes the states of the target apparatuses P, U, D, M to be monitored and is collected by the processing of the control unit 20.

The processing unit 23 can acquire sensor information (voltage data in time series, current data in time series, temperature data in time series) of the energy storage devices (energy storage modules, energy storage cells) collected in the database of the storage unit 22, by classifying the information into each energy storage device.

The processing unit 23 operates in a learning mode for causing the learning model 27 to learn and an estimation mode for estimating a state of health (SOH) (estimating degradation) of the energy storage device by using the learning-completed learning model 27. The SOH is an index comparing a full charge capacity at present with a full charge capacity of a new product at a predetermined temperature. For example, a SOH of 80% means a capacity of only 80% of that of a new product. Alternatively, instead of the capacity, the amount of electric power that can be charged and discharged may be used as a reference. In general, when the SOH becomes smaller than a threshold value, the energy storage device reaches its life and is determined to be not usable.

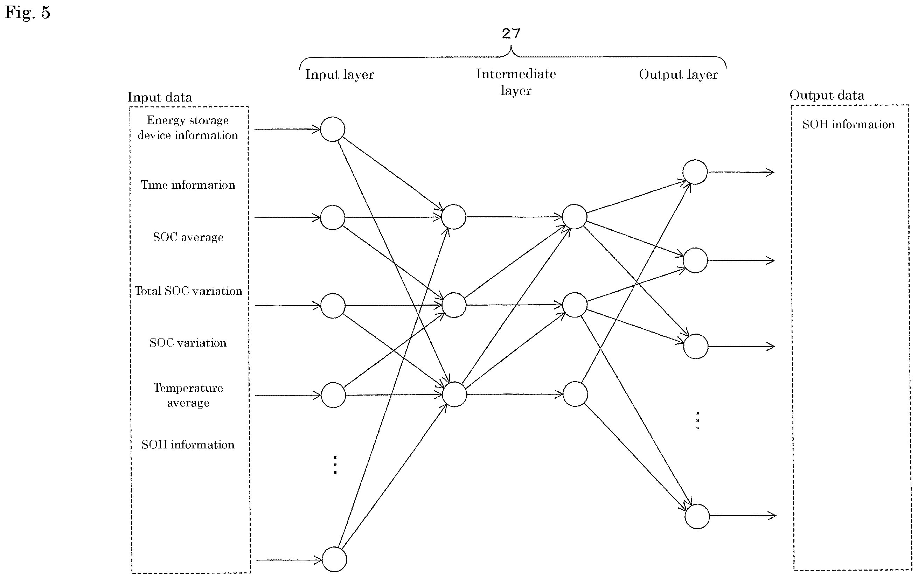

Fig. 5 is a schematic diagram showing an example of the configuration of the learning model 27. The learning model 27 is a neural network model including deep learning and is made up of an input layer, an output layer, and a plurality of intermediate layers. Although two intermediate layers are shown in Fig. 5 for convenience, the number of intermediate layers is not limited to two but may be three or more.

In the input layer, the output layer, and the intermediate layer, there are one or more nodes (neurons), and the node of each layer is coupled in one direction with a desired weight to each of the nodes existing in the preceding and succeeding layers. A vector having the same number of components as the number of nodes of an input layer is provided as input data of the learning model 27 (input data for learning and input data for SOH estimation). The input data includes energy storage device information, time information, a SOC average, a total SOC variation amount, a SOC variation range, a temperature average, SOH information, and the like. The output data includes SOH information. Details of these information will be described later. Particularly, the information on the SOC and the temperature information are related to each other, and local variations in the information on the SOC and the temperature information are related to a change in SOH, so that it is desirable to use convolutional neural networks in which a convolutional layer and a pooling layer that reflect those changes are added to an intermediate layer.

Data provided to each node of the input layer is input into the first intermediate layer, where the output of the intermediate layer is calculated using weights and activation functions, and the calculated values are provided to the next intermediate layer and are similarly transferred to subsequent layers (lower layer) in sequence until the output of the output layer is obtained in the same manner. Note that all the weights combining the nodes are calculated by a learning algorithm.

The output layer of the learning model 27 generates SOH information as output data. The output data can be data in a vector format having components of the same size as the number of nodes (size of the output layer) of the output layer. For example, when the SOH of the energy storage device is output every 1% from 0% to 100%, the number of nodes of the output layer can be set to 101. As practical SOH information, for example, when the SOH is estimated every 1% between 60% and 100%, the number of nodes of the output layer may be set to 41. In addition, a SOH value may be divided at intervals of several percent, and output data may be output at intervals of several percent. Note that the output value from the output layer can be interpreted as the probability of being classified into each segment of the SOH.

The learning model 27 and the learning processing unit 28 can be configured, for example, by combining hardware such as a CPU (e.g., multiple processors mounted with a plurality of processor cores, etc.), a graphics processing unit (GPU), a digital signal processor (DSP), a field-programmable gate array (FPGA), and the like. A quantum processor can also be combined. The learning model 27 is not limited to a neural network model but may be other machine learning models.

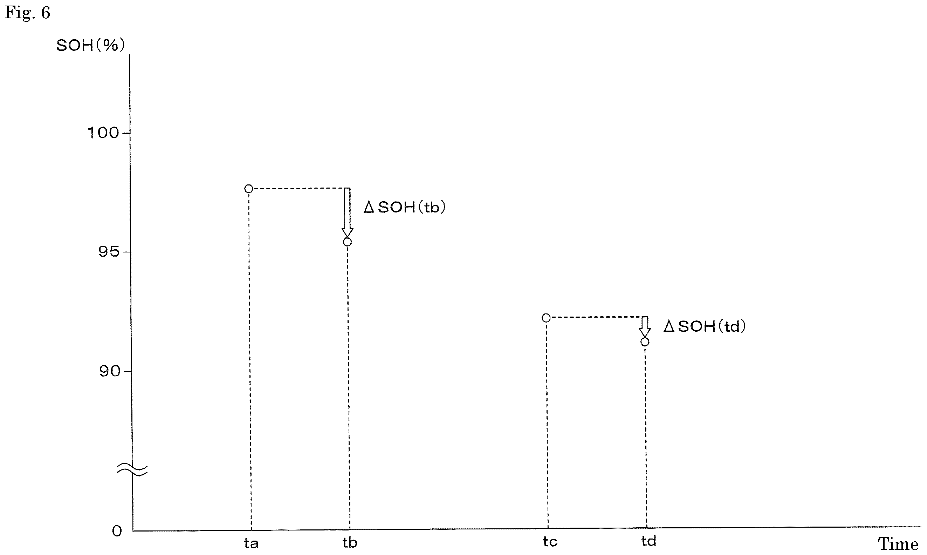

Fig. 6 is a schematic diagram showing an example of a decrease in SOH in accordance with the use time of the energy storage device. In the figure, the vertical axis indicates the SOH (%), and the horizontal axis indicates the time. The SOH of the energy storage device decreases with the use time (including the standing time). As shown in Fig. 6, time points ta, tb, tc, and td are set, and the time points tb and ta are set to be the same as the time points td and tc. In this case, a SOH decrease ΔSOH from the time point ta to the time point tb (tb) differs from a SOH decrease ΔSOH from the time point tc to the time point td (td). As described above, even in the same use period, the degree of decrease in SOH differs depending on the use state of the energy storage device. Therefore, for specifying various use states of the energy storage device, grasping the use states of the energy storage device between two different time points is important in order to estimate the SOH of the energy storage device.

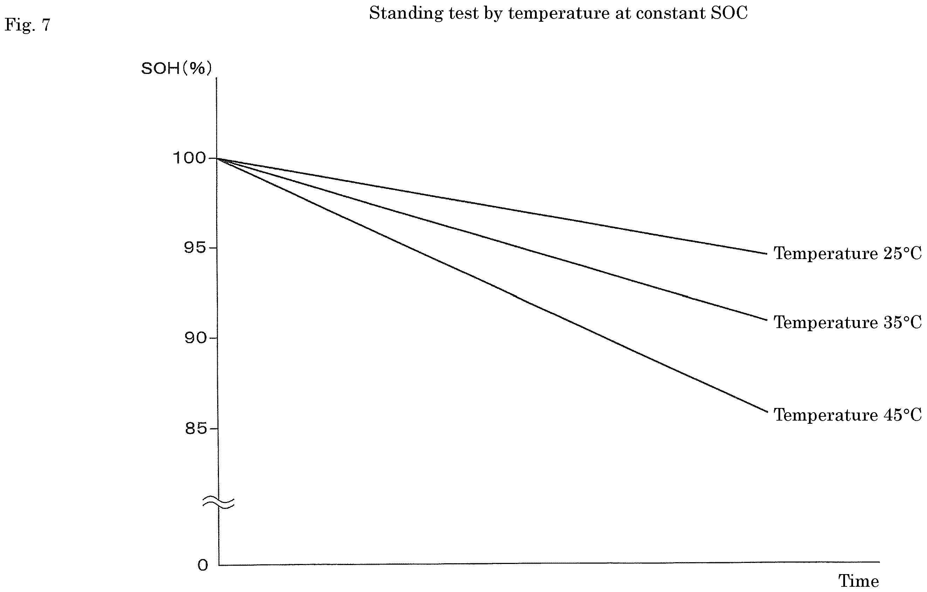

Fig. 7 is a schematic diagram showing an example of the relationship between the temperature and the decrease in SOH in a standing test in a constant SOC. In the figure, the vertical axis indicates the SOH, and the horizontal axis indicates the time. As shown in Fig. 7, it is found that the higher the temperature of the energy storage device, the greater the degree of decrease in SOH. That is, there is a correlation between the decrease (drop) in SOH and the temperature (average temperature), and the temperature (average temperature) becomes important information in the case of estimation (prediction) of the SOH.

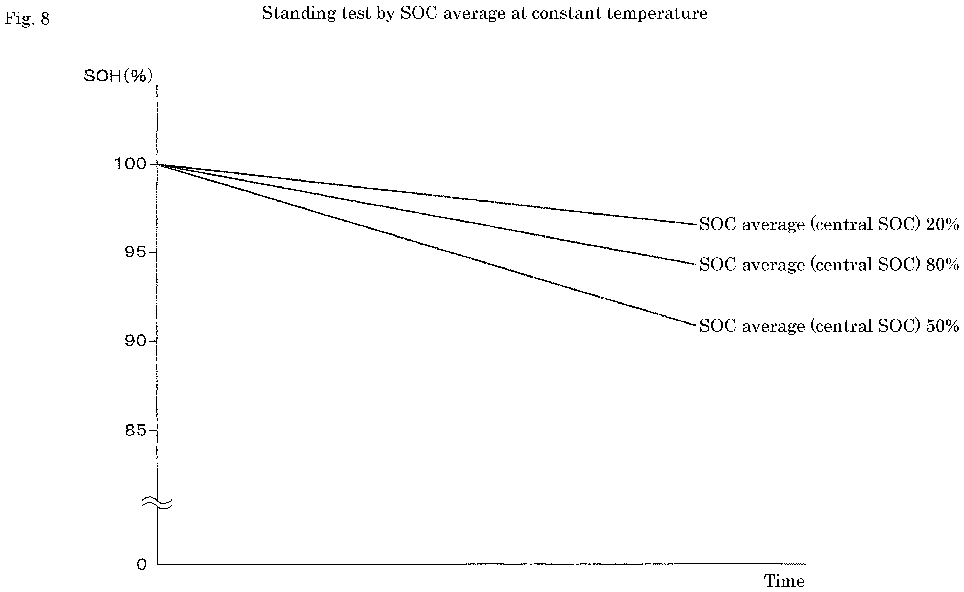

Fig. 8 is a schematic diagram showing an example of the relationship between the SOC average and the decrease in SOH in a standing test at a constant temperature. In the figure, the vertical axis indicates the SOH, and the horizontal axis indicates the time. The SOC average is a value obtained by dividing a value, obtained by sampling and summing SOC values within a certain period, by the number of samples, and the SOC average is a central SOC. As shown in Fig. 8, when the SOC average is different, the degree of decrease in SOH is different. That is, there is a correlation between the decrease (drop) in SOH and the SOC average, and the SOC average is an important representative value in the case of estimation (prediction) of the SOH.

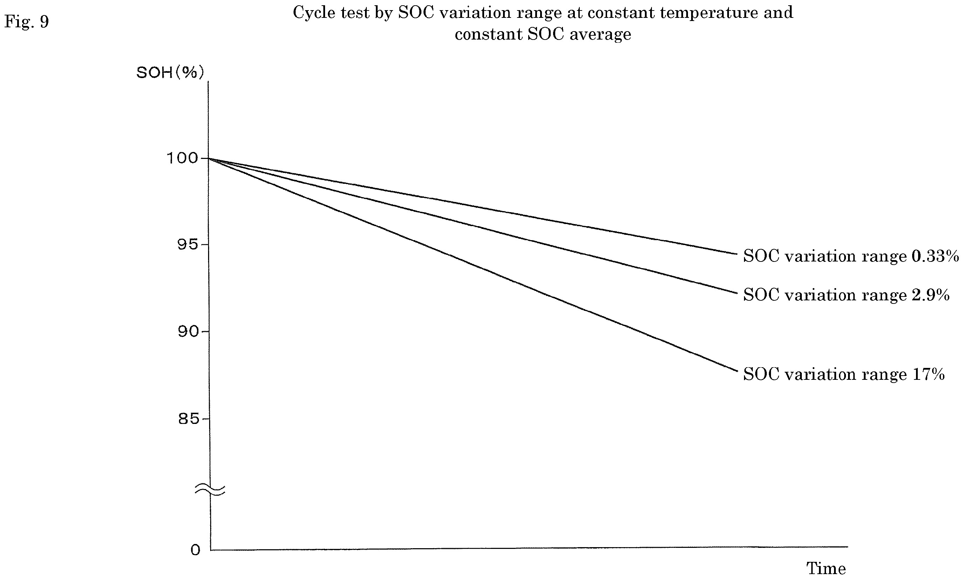

Fig. 9 is a schematic diagram showing an example of the relationship between the SOC variation range and the decrease in SOH in a cycle test at a constant temperature and a constant SOC average. In the figure, the vertical axis indicates the SOH, and the horizontal axis indicates the time. The SOC variation range is a difference between the maximum value and the minimum value of the SOC during a certain period when the SOC varies during the period. As shown in Fig. 9, it is found that the greater the SOC variation range, the greater the degree of decrease in SOH. That is, there is a correlation between the decrease (drop) in SOH and the SOC variation range, and the SOC average is an important representative value in the case of estimation (prediction) of the SOH.

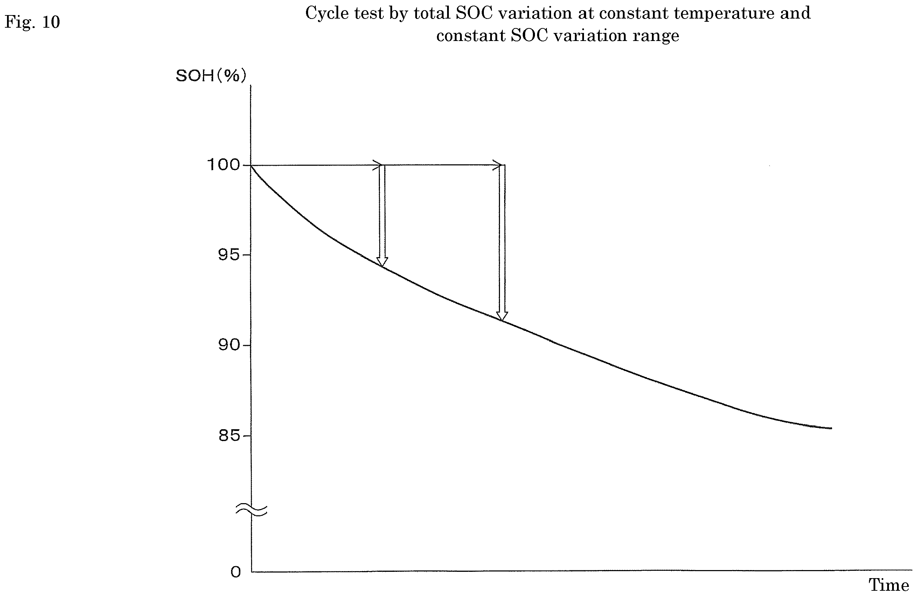

Fig. 10 is a schematic diagram showing an example of the relationship between the total SOC variation amount and the decrease in SOH in a cycle test at a constant temperature and a constant SOC variation range. In the figure, the vertical axis indicates the SOH, and the horizontal axis indicates the time. The total SOC variation amount is the integration of variation amounts along a route of how the SOC has varied in a certain period. As shown in Fig. 10, it is found that the greater the total SOC variation amount, the greater the degree of decrease in SOH. That is, there is a correlation between the decrease (drop) in SOH and the total SOC variation amount, and the total SOC variation amount is an important representative value in the case of estimation (prediction) of the SOH.

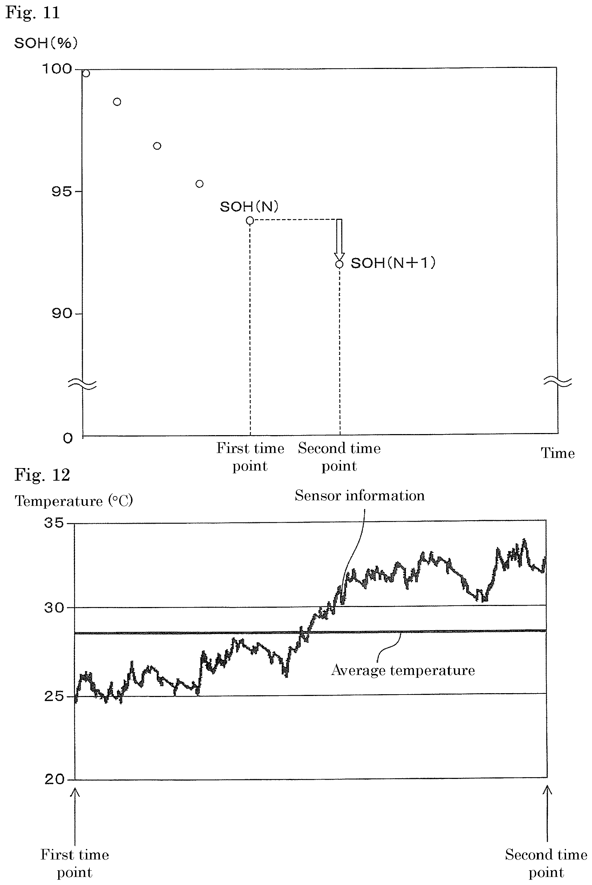

Fig. 11 is a schematic diagram showing an example of a decrease in SOH of the energy storage device at each of the first and second time points. The SOH at the first time point is represented by SOH(N), and the SOH at the second time point is represented by SOH(N+1). The decrease in SOH {SOH(N) - SOH(N+1)} at the second time point differs depending not only on the SOH(N) at the first time point but also on the use state of the energy storage device from the first time point to the second time point. In other words, by specifying the SOH(N) of the energy storage device at the first time point, the SOH(N+1) of the energy storage device at the second time point can be estimated when the use state of the energy storage device from the first time point to the second time point is known. Further, as described above, the use state from the first time point to the second time point can be characterized by the temperature (average temperature) of the energy storage device and the representative value relating to the SOC.

In the following, first, the learning mode of the learning model 27 will be described.

The processing unit 23 has a function as a SOH acquisition unit and acquires the SOH of the energy storage device at the first time point and the SOH at the second time point after the first time point. The energy storage device may be, for example, an energy storage device actually operating in a mobile body or facility. The SOH can be estimated by a known method based on the sensor information. Alternatively, the SOH may be estimated using a method described in Japanese Patent Application No. 2017-065532 (its entire contents are incorporated herein by reference). The period between the first time point and the second time point can be appropriately set and may be, for example, one month or three months. When the sensor information has periodicity, the period between the first time point and the second time point may be divided by the cycle of the sensor information. At that time, an interpolation value at the first and second time points may be used for the SOH. As the SOH at the first time point, a value estimated by the learning-completed learning model 27 based on the SOH at a time point before the first time point can also be used. Hence, it is possible to continuously estimate in any period the SOH of the energy storage device in the use period (including a standing period) after the manufacturing of the energy storage device.

The SOC representative value acquisition unit 25 has a function as a representative value acquisition unit and acquires a SOC representative value of the energy storage device from the first time point to the second time point. In the energy storage device (e.g., lithium ion battery), a solid electrolyte interface layer (SEI layer) is generated at an interface between an electrode and an electrolyte solution by charging and discharging or standing, and the SOH decreases as the SEI layer grows. Based on the hypothesis that the growth of the SEI layer depends on the SOC, the present inventors have proposed to acquire a SOC representative value that affects a decrease in the SOH of the energy storage device and use the representative value for AI learning. The SOC representative value can be said to be information that abstracts the detailed behavior of the energy storage device in operation. Note that the SOC representative value may be obtained from an external server apparatus or the like.

A learning data generation unit 26 generates learning data with the SOH at the first time point and the SOC representative value between the first time point and the second time point as input data and with the SOH at the second time point as output data.

The learning processing unit 28 learns the learning model 27 based on the learning data generated by the learning data generation unit 26.

The learning data generation unit 26 need not be provided in the server apparatus 2 but may be provided in another server apparatus so that the learning data generated in the server apparatus may be acquired, and the learning processing unit 28 may cause the learning model 27 to learn based on the acquired learning data. The same applies to the following description of the present specification.

Assuming that the SOH at the first time point is represented by SOH(N), and the SOH at the second time point is represented by SOH(N+1). The learning model 27 learns that the SOH at the first time point is SOH(N), and the SOH at the second time point is SOH(N+1) in accordance with a SOC representative value of the energy storage device from the first time point to the second time point.

Such learning data includes the SOH at the first time point, the SOH at the second time point, and the SOC representative value between the first time point and the second time point. The SOC representative value can be said to be a statistic obtained by abstracting or processing information for causing the learning model 27 to learn. Thus, the learning model 27 can be caused to learn with a relatively small amount of information, and a large amount of data of the energy storage device is not required.

When a SOH at a certain time point (e.g., at present) and a SOC representative value from the time point to a prediction target point are input to the learning-completed learning model 27, a SOH at the prediction target point can be estimated. Thereby, the degradation of the energy storage device can be estimated using the AI.

Next, the average temperature characterizing the use state of the energy storage device between the first time point and the second time point and a SOC representative value will be described.

Fig. 12 is a schematic diagram showing an example of temperature data from the first time point to the second time point. In the figure, the vertical axis indicates the temperature, and the horizontal axis indicates the time. The processing unit 23 calculates the average temperature between the first time point and the second time point based on the temperature data between the first time point and the second time point. In the example of Fig. 12, temperature data has been obtained in detail between the first time point and the second time point, but the average temperature between the first time point and the second time point can be obtained even when the number of data is small.

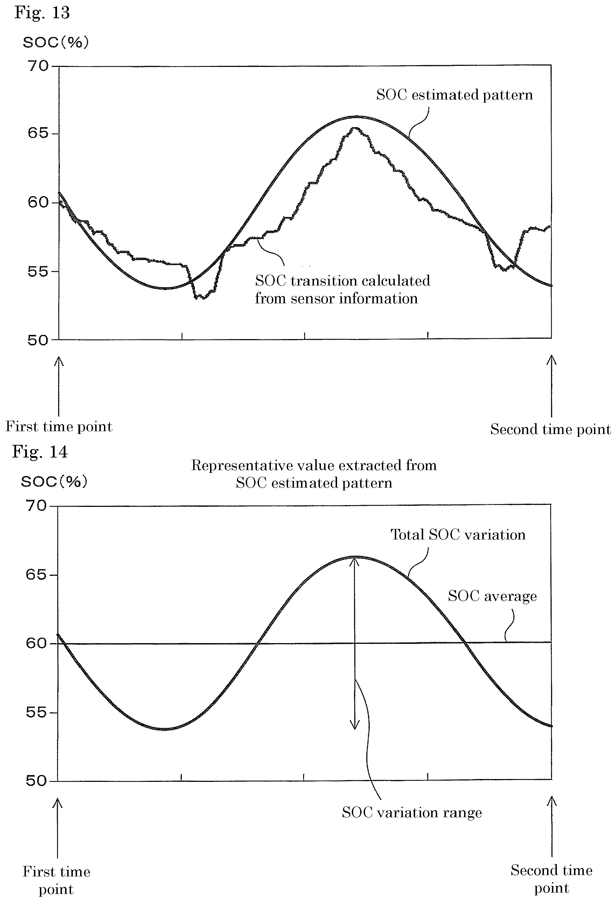

Fig. 13 is a schematic diagram showing an example of a SOC transition pattern from the first time point to the second time point. In the figure, the vertical axis indicates the SOC, and the horizontal axis indicates the time. The SOC estimation unit 24 estimates the SOC transition of the energy storage device from the first time point to the second time point. In the example shown in Fig. 13, SOC time-series data of the energy storage device between the first time point and the second time point has been obtained in detail, but the SOC transition pattern between the first time point and the second time point can be obtained even when the number of data is small. For example, in a case where the amount of data in the time series of the SOC of the energy storage device from the first time point to the second time point is not sufficient, and there exists a time or time zone in which the value of the SOC is unknown, a SOC transition pattern can be estimated by interpolating a SOC value at a place where data exists based on the obtained data of the SOC. This eliminates the need for a large amount of sensor information.

Fig. 14 is a schematic diagram showing an example of a SOC representative value between the first time point and the second time point. In the figure, the vertical axis indicates the SOC, and the horizontal axis indicates the time. The SOC representative value acquisition unit 25 acquires a SOC average from the first time point to the second time point based on the SOC transition pattern. The SOC average is a value obtained by dividing a value, obtained by sampling and summing SOC values from the first time point to the second time point, by the number of samples, and the SOC average is a central SOC. When the SOC of the energy storage device varies, the degree of decrease in SOH differs depending on the SOC average. The learning data generation unit 26 generates data for learning with the average SOC from the first time point to the second time point as input data. Therefore, by causing the learning model 27 to learn the SOC average from the first time point to the second time point, it is possible to generate a learning-completed learning model 27 that can accurately estimate a SOH.

The SOC representative value acquisition unit 25 acquires a total SOC variation amount from the first time point to the second time point based on the SOC transition pattern. The total SOC variation amount is the integration of variation amounts along a route of how the SOC has varied from the first time point to the second time point. When the SOC of the energy storage device varies, the degree of decrease in SOH differs depending on the total SOC variation amount. The learning data generation unit 26 generates data for learning with the total SOC variation amount from the first time point to the second time point as input data. By causing the learning model 27 to learn the total SOC variation amount from the first time point to the second time point, it is possible to generate a learning-completed learning model 27 that can accurately estimate a SOH.

The SOC representative value acquisition unit 25 acquires a SOC variation range from the first time point to the second time point based on the SOC transition pattern. The SOC variation range is a difference between the maximum value and the minimum value of the SOC from the first time point to the second time point. When the SOC of the energy storage device varies, the degree of decrease in SOH differs depending on the SOC variation range. The learning data generation unit 26 generates data for learning with the SOC variation range from the first time point to the second time point as input data. By causing the learning model 27 to learn the SOC variation range from the first time point to the second time point, it is possible to generate a learning-completed learning model 27 that can accurately estimate a SOH. As described above, in the first embodiment, the SOC representative value can be the SOC average from the first time point to the second time point, the total SOC variation amount from the first time point to the second time point, and the SOC variation range from the first time point to the second time point.

The learning data generation unit 26 generates data for learning with the average temperature between the first time point and the second time point as input data. The average temperature can also be regarded as the temperature transition between the first time point and the second time point.

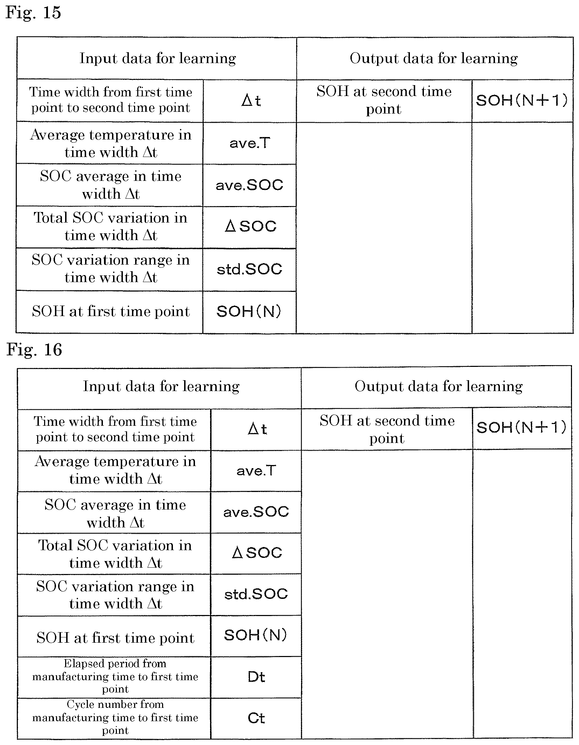

Fig. 15 is a configuration diagram showing an example of data for learning. In the example of Fig. 15, a time width from the first time point to the second time point is represented by Δt. As shown in Fig. 15, input data for learning may be a time width Δt from the first time point to the second time point, an average temperature in the time width Δt, a SOC average in the time width Δt, a total SOC variation amount in the time width Δt, a SOC variation range in the time width Δt, and SOH(N) at the first time point. Output data for learning can be SOH(N+1) at the second time point. Note that the input data for learning need not include all the data shown in Fig. 15, and for example, either or both the total SOC variation amount and the SOC variation range may be omitted. However, by learning the total SOC variation amount and the SOC variation range, the estimation accuracy of the SOH can be expected to be improved.

Fig. 16 is a block diagram showing another example of the data for learning. The difference from the example of Fig. 15 is that the input data for learning may further include an elapsed time Dt1 from the point of manufacturing (e.g., the point of completion of manufacturing) to the first time point, and a cycle number of charge and discharge Ct1 from the point of manufacturing (e.g., the point of completion of manufacturing) to the first time point.

The learning data generation unit 26 can generate learning data with the elapsed period from the point of manufacturing the energy storage device to the first time point as input data. The SOH of the energy storage device decreases with the standing time (calendar degradation). The decrease in SOH after the first time point is considered to depend on the length of time elapsed from the point of manufacturing (e.g., the point of completion of manufacturing) to the first time point. Therefore, by further generating learning data with the elapsed period from the point of manufacturing the energy storage device to the first time point as input data, it is possible to generate a learning-completed learning model 27 that can accurately estimate the SOH.

The learning data generation unit 26 can generate learning data with a total amount of energized electricity (e.g., a cycle number of charge and discharge when the cycle number can be specified) from the point of manufacturing the energy storage device to the first time point as input data. The SOH of the energy storage device decreases with the cycle number of charge and discharge (cycle degradation). The decrease in SOH after the first time point is considered to depend somewhat on the cycle number of charge and discharge from the point of manufacturing (e.g., the point of completion of manufacturing) to the first time point. Therefore, when it is possible to specify the cycle number of charge and discharge, by further generating learning data with the cycle number of charge and discharge from the point of manufacturing the energy storage device to the first time point as input data, it is possible to generate a learning-completed learning model 27 that can accurately estimate the SOH. Note that the learning data may be generated using only either the elapsed time Dt1 or the cycle number of charge and discharge Ct1. When it is not possible to specify the cycle number of charge and discharge, the total amount of energized electricity may be used instead of the cycle number of charge and discharge.

In the example described above, the example of setting only one learning period from the first time point to the second time point has been described, but the invention is not limited thereto.

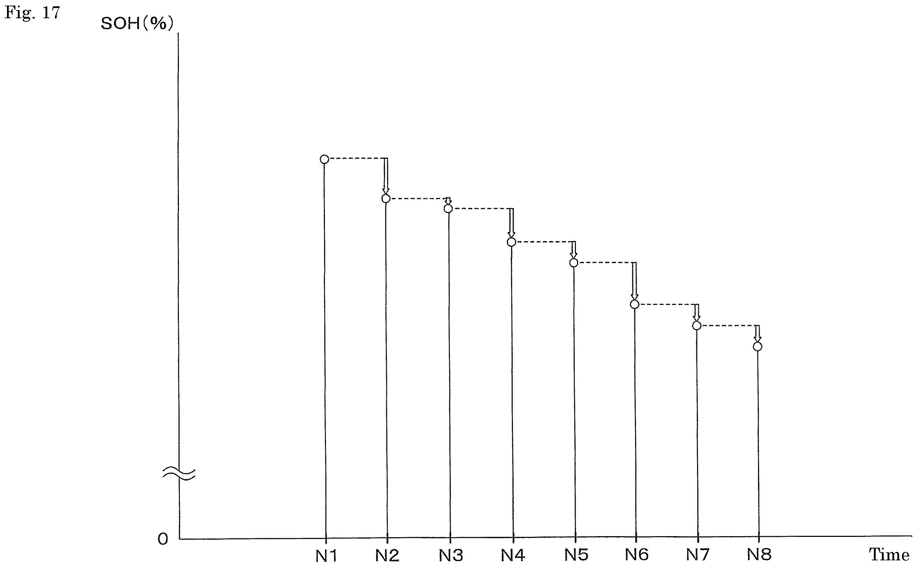

Fig. 17 is a schematic diagram showing an example in which a plurality of learning periods are set. In the figure, the vertical axis indicates the SOH, and the horizontal axis indicates the time. As shown in Fig. 17, time point N1, time point N2, time point N3, time point N4, time point N5, time point N6, time point N7, and time point N8 are set. The time between adjacent time points may be different. A learning period can be set with the time point N1 as the first time point and the time point N2 as the second time point. Also, a learning period can be set with the time point N2 as the first time point and the time point N3 as the second time point. The same applies hereinafter.

As shown in Fig. 17, the learning data generation unit 26 can generate learning data by providing a plurality of learning periods from the first time point to the second time point over the use period of the energy storage device. Assuming that the learning period from the first time point to the second time point is ΔN, it is possible to estimate a SOH at a required time point after the manufacturing of the energy storage device to reach the life by causing the learning model 27 to learn using data for learning for each of the plurality of learning periods ΔN over the use period from the point of manufacturing to the life of the energy storage device, for example. That is, the life of the energy storage device can be predicted.

Next, the estimation mode for estimating the SOH will be described.

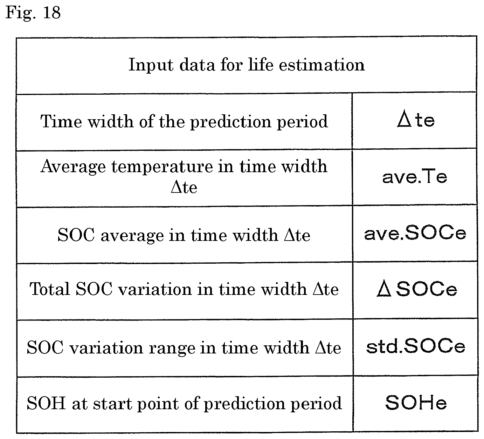

Fig. 18 is a block diagram showing an example of input data for life estimation. As shown in Fig. 18, the input data for life estimation may be a time width Δte of a prediction period, an average temperature in the time width Δte, a SOC average in the time width Δte, a total SOC variation amount in the time width Δte, a SOC variation range in the time width Δte, and SOHe at a start point (first time point) of the prediction period. The time width Δte may be the same as the time width from the first time point to the second time point used in the data for learning. The input data for life estimation need not include all the data shown in Fig. 18, and for example, either or both the total SOC variation amount or the SOC variation range may be omitted. However, by adding the total SOC variation amount and the SOC variation range to the input data, the estimation accuracy of the SOH can be expected to be improved.

The input data generation unit 29 generates input data for life estimation based on the SOH at the first time point and the SOC representative value of the energy storage device from the first time point to the second time point. Specifically, the input data generation unit 29 generates input data relating to the time width Δte of the prediction period, the average temperature in the time width Δte, the SOC average in the time width Δte, the total SOC variation amount in the time width Δte, the SOC variation range in the time width Δte, and SOHe at a start point (first time point) of the prediction period as illustrated in Fig. 18. For example, as SOHe at the first time point, a value estimated by the learning-completed learning model 27 based on the SOH at a time point before the first time point can also be used. Thus, the SOH can be continuously estimated in any period.

The learning-completed learning model 27 estimates a SOH at a prediction target point (an end point of the prediction period, i.e., the second time point) based on the input data generated by the input data generation unit 29. Thus, when the SOH at the first time point (e.g., at present) and the SOC representative value of the energy storage device in the prediction period are known, the SOH at the prediction target point can be estimated. Further, by using the SOH at the first time point, it can also be determined how to set the SOC representative value of the energy storage device in the prediction period to enable an increase in SOH at the prediction target point (prevention of a decrease in SOH).

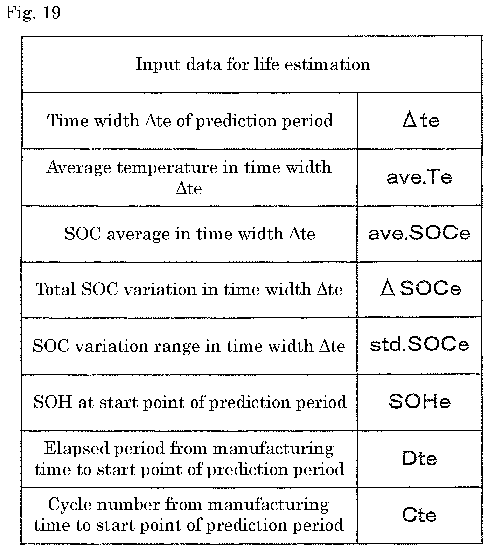

Fig. 19 is a block diagram showing another example of the input data for life estimation. The difference from the example of Fig. 18 is that the input data further includes an elapsed time Dte from the point of manufacturing (e.g., the point of completion of manufacturing) to the start point of the prediction period, and a cycle number of charge and discharge Cte from the point of manufacturing (e.g., the point of completion of manufacturing) to the start point of the prediction period.

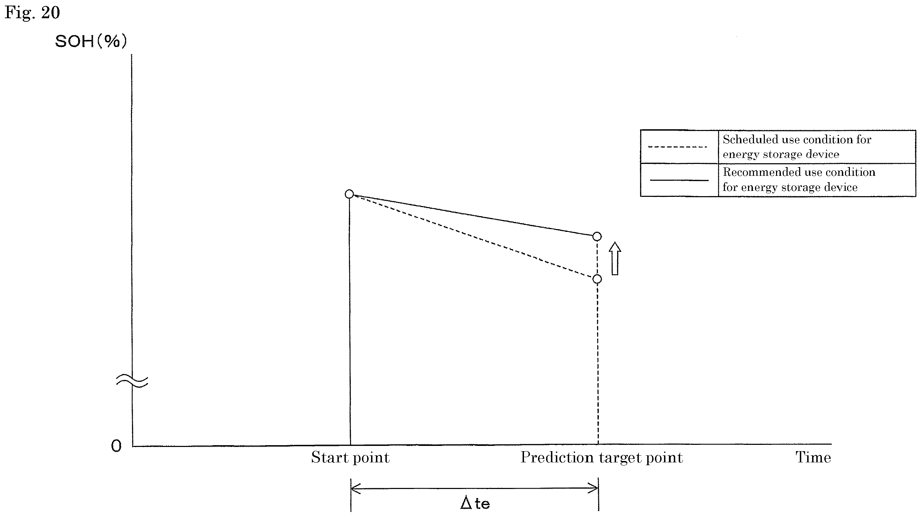

Fig. 20 is a schematic diagram showing an example of a degradation estimation result of the energy storage device. In the figure, the vertical axis indicates the SOH, and the horizontal axis indicates the time. At the start point (e.g., at present) of the prediction period, the learning-completed learning model 27 estimates a SOH at a future prediction target point. In Fig. 20, a curve indicated by a broken line shows a SOH transition in a scheduled use condition (e.g., the user's scheduled use state) from the present to the prediction target point of the energy storage device. According to the server apparatus 2 of the present embodiment, the SOH can be estimated by changing the use condition of the energy storage device from the present to the prediction target point. For example, as shown by a curve indicated by a solid line, a use condition (recommended use condition) that can prevent a decrease in SOH at the prediction target point can be found. By using the SOH at present (the start point), that is, the SOH at the first time point, it is possible to provide information on how to set the use condition of the energy storage device from the start point to the prediction target point with reference to the first time point to enable prevention of a decrease in SOH.

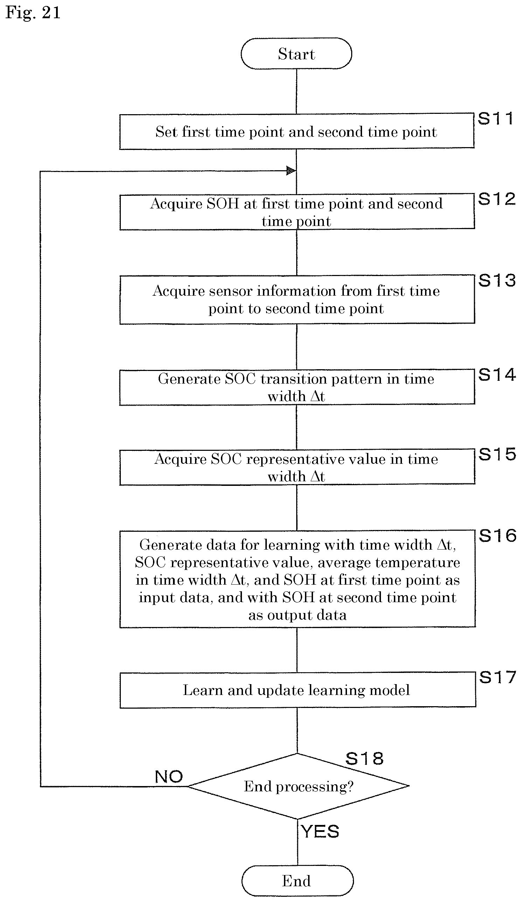

Fig. 21 is a flowchart showing an example of the processing procedure of the processing unit 23 in the learning mode. The processing unit 23 sets the first and second time points (S11) and acquires SOHs at the first and second time points (S12). The processing unit 23 acquires sensor information (time-series current data, time-series temperature data, time-series voltage data) from the first time point to the second time point (S13).

The processing unit 23 generates a SOC transition pattern with a time width Δt from the first time point to the second time point based on the acquired sensor information (S14) and acquires a SOC representative value with the time width Δt (S15). The processing unit 23 generates data for learning with the time width Δt, the SOC representative value, an average temperature in the time width Δt, and the SOH at the first time point as input data, and with the SOH at the second time point as output data (S16).

The processing unit 23 performs the learning and update of the learning model 27 based on the generated data for learning (S17) and determines whether or not to end the processing (S18). When it is determined not to end the processing (NO in S18), the processing unit 23 continues the processing from S12, and when it is determined to end the processing (YES in S18), the processing is ended.

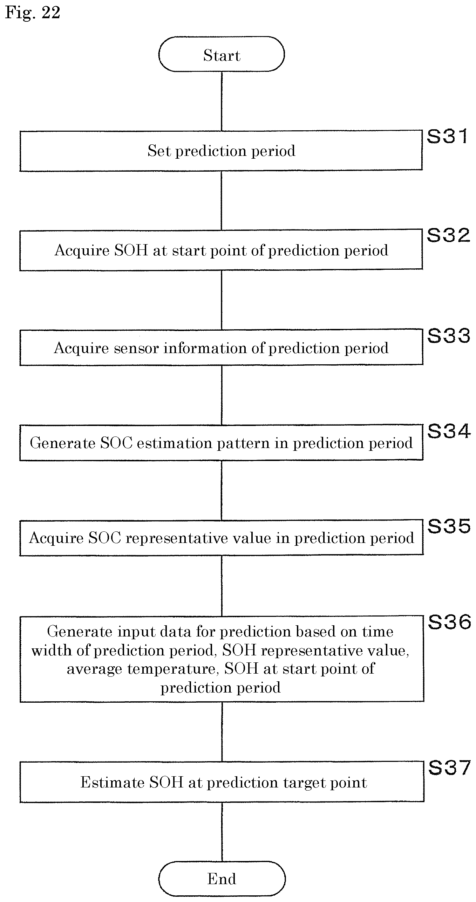

Fig. 22 is a flowchart showing an example of the processing procedure of the processing unit 23 in the estimation mode. The processing unit 23 sets a prediction period (S31) and acquires SOH at the start point (the first time point) of the prediction period (S32). The processing unit 23 acquires sensor information in the prediction period (S33) and generates a SOC transition pattern in the prediction period based on the acquired sensor information (S34).

The processing unit 23 acquires a SOC representative value in the prediction period (S35) and generates input data for prediction based on a time width of the prediction period, a SOC representative value, an average temperature, and the SOH at the start point of the prediction period (S36). The processing unit 23 estimates the SOH at the prediction target point (S37) and ends the processing.

As described above, according to the server apparatus 2 of the present embodiment, a large amount of data is not required at the time of causing the learning model 27 to learn. The SOC representative value characterizing the use state of the energy storage device can be acquired, and the learning model 27 can be caused to learn based on the acquired representative value, so that the learning is possible even with a small amount of data. In particular, even in a stage where it is difficult to acquire a large amount of sensor information during the actual operation of the energy storage device, such as in a development phase or an initial stage of a manufacturing phase of the energy storage device, it is possible to predict the degradation of the energy storage device. Since the sensor information is not used as data for learning as it is, the influence of an error included in the sensor information can be prevented. The learning model 27 may use a convolutional neural network (CNN) in which a convolutional layer or a pooling layer is added to an intermediate layer. Thus, the learning model 27 performs learning while being reflected by the relation between the SOC information and the temperature information and the relation between the local variation in the SOC information and the temperature information and the change of the SOH.

### (Second Embodiment)

In the first embodiment described above, the abstracted data of the SOC representative value has been used, but the present invention is not limited thereto. In a second embodiment, the degree of abstraction is reduced to enable generation of data for learning in an aspect closer to time-series data such as sensor information.

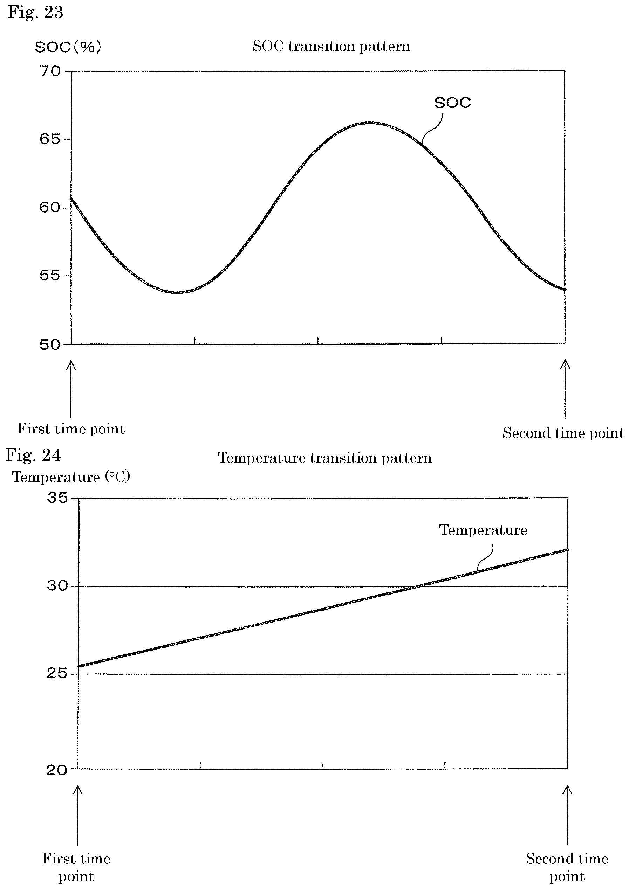

Fig. 23 is a schematic diagram showing an example of a SOC transition pattern of the energy storage device from the first time point to the second time point. The SOC transition pattern shown in Fig. 23 is the same as that shown in Fig. 13. The SOC estimation unit 24 generates a SOC transition pattern of the energy storage device between the first time point and the second time point. For example, in a case where the amount of data in the time series of the SOC of the energy storage device from the first time point to the second time point is not sufficient, and there exists a time or time zone in which the value of the SOC is unknown, the SOC transition pattern can be generated by interpolating a SOC value at a place where data exists based on the obtained data of the SOC. This eliminates the need for a large amount of sensor information.

The SOC representative value acquisition unit 25 acquires the SOC transition pattern generated by the SOC estimation unit 24 as a representative value. The degree of decrease in SOH differs depending on the SOC transition pattern from the first time point to the second time point. As described above, in the second embodiment, the SOC representative value can be the SOC transition pattern from the first time point to the second time point.

Fig. 24 is a schematic diagram showing an example of the temperature transition pattern of the energy storage device from the first time point to the second time point. In the figure, the vertical axis indicates the temperature, and the horizontal axis indicates the time. The processing unit 23 generates a temperature transition pattern of an energy storage device between the first time point and the second time point. For example, in a case where the amount of data in the time series of the temperature of the energy storage device from the first time point to the second time point is not sufficient, and there exists a time or time zone in which the value of the temperature is unknown, a temperature transition pattern can be estimated by interpolating a temperature value at a place where data exists based on the obtained data of the temperature. This eliminates the need for a large amount of sensor information. Note that the processing unit 23 has a function as an acquisition unit for acquiring a temperature transition and may acquire a temperature transition pattern or a measured value of a temperature transition of the energy storage device. The processing unit 23 may acquire a temperature representative value. The temperature representative value can be a statistic obtained by abstracting or processing information for causing the learning model 27 to learn. The temperature representative value is the same as, for example, the SOC representative value shown in Fig. 14 and may include a temperature average, a temperature variation range, a total temperature variation amount, and the like.

The learning data generation unit 26 can generate learning data with the SOC transition pattern and the temperature transition pattern as input data. The degree of decrease in SOH differs depending on the temperature transition pattern from the first time point to the second time point. Therefore, by causing the learning model 27 to learn the SOC transition pattern and the temperature transition pattern from the first time point to the second time point, it is possible to generate a learning-completed learning model 27 that can accurately estimate a SOH. As the learning data, the time between the first time point and the second time point may be separated by a plurality of time widths, and values for each time width of the time series of the SOC transition pattern and the temperature transition pattern may be used. The second embodiment is the same as the first embodiment in that in the learning data, the SOH at the first time point is the input data, and the SOH at the second time point is the output data. Note that the learning data generation unit 26 can generate learning data with the SOC transition pattern and the measured value or the representative value of the temperature transition as input data.

According to the second embodiment, in a stage where more sensor information can be collected than in the first embodiment, it is possible to predict degradation, reflecting characteristics of the sensor information itself.

### (Third Embodiment)

Although the learning processing unit 28 (processing unit 23) has caused the learning or update of the learning model 27 in the first and second embodiments described above, in a third embodiment, the learning processing unit 28 (processing unit 23) can cause the learning model 27 to learn using a degradation value (SOH) of the energy storage device output by a degradation simulator to be described later as learning data and can cause the learning-completed learning model 27 to relearn by using the same processing as in the first and second embodiments. The third embodiment will be described below.

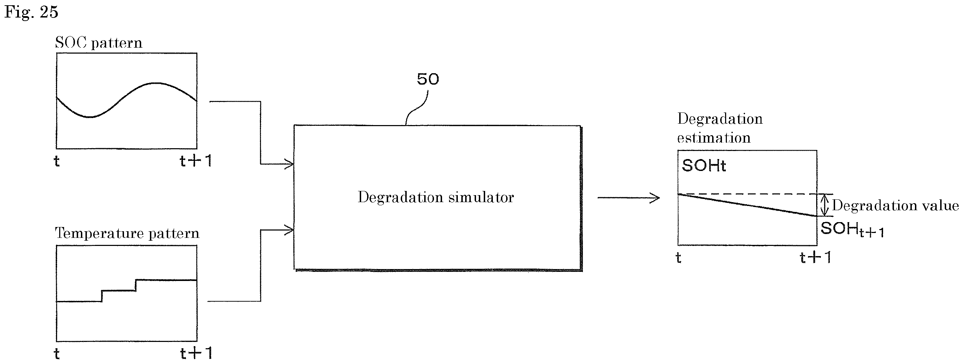

Fig. 25 is a schematic diagram showing an operation of a degradation simulator 50 according to a third embodiment. When acquiring a SOC pattern and a temperature pattern as input data, the degradation simulator 50 estimates (calculates) a degradation value of the energy storage device. The SOC pattern can be specified by a SOC representative value. The SOC representative value affects the degradation of the energy storage device and includes, for example, a SOC average (also known as a central SOC), a SOC variation range, a total SOC variation amount, and the like.

That is, the degradation simulator 50 can estimate a degradation value of the SOH of the energy storage device on the basis of the SOC transition based on the SOC representative value and of the temperature of the energy storage device. Assuming that a SOH (also referred to as health) at time point t is SOHₜ and a SOH at time point t+1 is SOHₜ₊₁, the degradation value becomes (SOHₜ - SOHₜ₊₁). That is, when the SOH at time point t is known, the SOH at time point t+1 can be obtained based on the degradation value. Here, the time point may be a present or future time point, and the time point t+1 may be a time point at which a required time has elapsed from the time point t toward the future. A time difference between the time point t and the time point t+1 is a degradation prediction target period of the degradation simulator 50 and can be appropriately set depending on a degree of future prediction of the degradation value. The time difference between the time point t and the time point t+1 can be a required time, such as one month, half year, one year, or two years.

In the example of Fig. 25, although the temperature pattern is to be input, a required temperature (e.g., average temperature from time point t to time point t+1) may be input instead of the temperature pattern.

A degradation value Qdeg after the lapse of the degradation prediction target period (e.g., from time point t to time point t+1) of the energy storage device can be calculated by a formula Qdeg = Qcnd + Qcur. Here, Qcnd is a non-energization degradation value and Qcur is an energization degradation value. The non-energization degradation value Qcnd can be obtained by, for example, Qcnd = K1 × V(t). Here, a coefficient K1 is a function of a SOC and a temperature T. "t" is an elapsed time, for example, the time from time point t to time point t+1. The energization degradation value Qcur can be obtained by, for example, Qcur = K2 × V(t). Here, the coefficient K2 is a function of the SOC and the temperature T. Assuming that the SOH at time point t is SOHₜ and the SOH at time point t+1 is SOHₜ₊₁, the SOH can be estimated by SOHₜ₊₁ = SOHₜ - Qdeg.

The coefficient K1 is a degradation coefficient, and the correspondence relation between each of the SOC and the temperature T and the coefficient K1 may be obtained by calculation or stored in a table form. Here, the SOC may be a representative value, such as the central SOC or the SOC variation range. A coefficient K2 is the same as the coefficient K1.

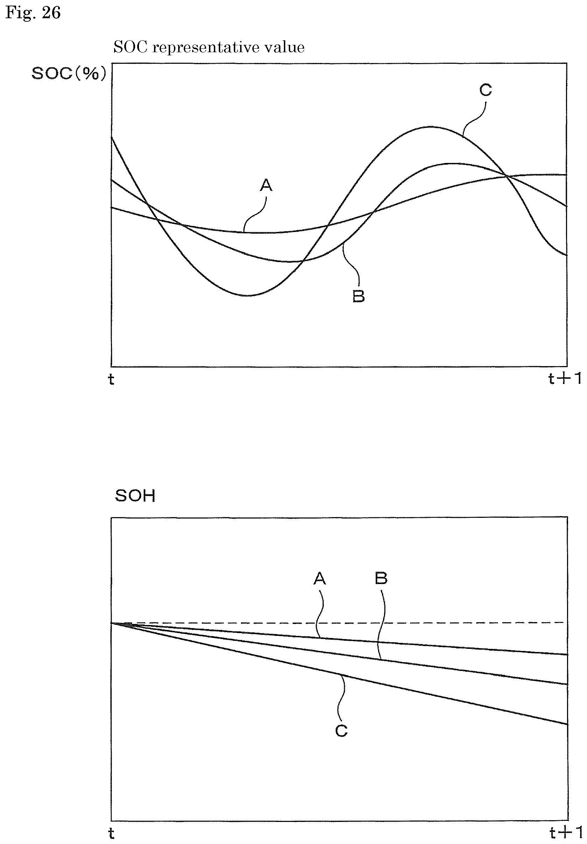

Fig. 26 is a schematic diagram showing an example of SOH estimation by the degradation simulator 50. As shown in Fig. 26, it is assumed that representative values (SOC patterns) of three SOCs indicated by symbols A, B, and C are input to the degradation simulator 50. The average temperature from the time point t to the time point t+1 is input as the temperature. The SOC pattern indicated by symbol A has a relatively small SOC variation range. On the other hand, the SOC pattern indicated by symbol C has a relatively large SOC variation range. The SOC pattern indicated by symbol B has a SOC variation range about the middle of both. As shown in Fig. 26, each of symbols A, B, and C indicates the estimation of the SOH by the degradation simulator 50. The SOH transition of symbol A corresponds to the SOC pattern of symbol A, the SOH transition of symbol B corresponds to the SOC pattern of symbol B, and the SOH transition of symbol C corresponds to the SOC pattern of symbol C. As described above, as the SOC variation range increases, the degradation value tends to increase.

Although the three relatively simple SOC patterns are illustrated in Fig. 26 for convenience, by inputting various SOC patterns into the degradation simulator 50, the degradation values (SOH) corresponding to the various SOC patterns can be estimated, and a set of data on an estimation result of the SOH corresponding to the SOC pattern can be easily generated in a large amount.

The processing unit 23 has a function as an input value acquisition unit and can acquire a SOC representative value input to the degradation simulator 50. The processing unit 23 has a function as an output value acquisition unit and can acquire a SOH output from the degradation simulator 50 when the SOC representative value is input to the degradation simulator 50. That is, the processing unit 23 acquires the SOC representative value input to the degradation simulator 50 and the SOH (determined by the degradation value) output from the degradation simulator 50 at that time.

The learning processing unit 28 uses the acquired SOC representative value and the acquired SOH as learning data to cause the learning model 27 to learn.

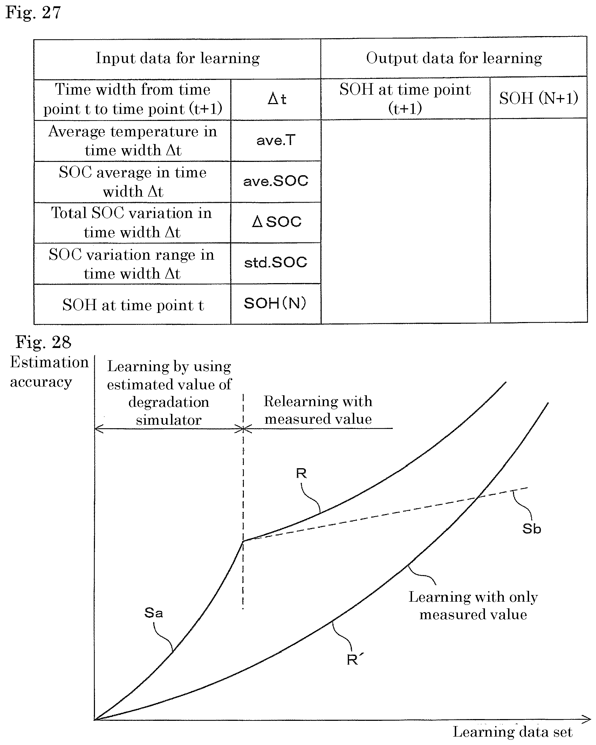

Fig. 27 is a block diagram showing an example of data for learning based on the estimated value of the degradation simulator 50. In the example of Fig. 27, a time width from time point t to time point t+1 is represented by Δt. As shown in Fig. 27, input data for learning may be a time width Δt from time point t to time point t+1, an average temperature in the time width Δt, a SOC average in the time width Δt, a total SOC variation amount in the time width Δt, a SOC variation range in the time width Δt, and SOH(N) at time point t. Output data for learning can be SOH(N+1) at time point t+1. Note that the input data for learning need not include all the data shown in Fig. 27, and for example, either or both the total SOC variation amount and the SOC variation range may be omitted. However, by learning the total SOC variation amount and the SOC variation range, the estimation accuracy of the SOH can be expected to be improved.

When representative values of SOCs of various patterns are input to the degradation simulator 50, the degradation simulator 50 outputs a degradation value (i.e., SOH) with high accuracy with respect to the input SOC representative values, thereby making it possible to easily generate data for learning of the learning model 27 and easily generate the estimation accuracy (percentage of correct answers) of the learning model 27.

Next, a description will be given of relearning processing by the learning processing unit 28 with respect to the learning model 27 caused to learn using the data for learning based on the data of the degradation simulator 50. The relearning processing by the learning processing unit 28 is the same as the learning processing in the first and second embodiments.

The SOC representative value acquisition unit 25 has a function as a representative value acquisition unit and acquires a SOC representative value of the energy storage device. The SOC representative value can be said to be information that abstracts the detailed behavior of the energy storage device in operation, can be obtained from the SOC transition obtained from the sensor information, and includes, for example, the SOC average, the total SOC variation amount, the SOC variation range, and the like. Note that the SOC representative value can be obtained based on the measured value of the SOC transition, but a calculated value may be used in addition to the measured value.

More specifically, the SOC representative value acquisition unit 25 acquires a SOC representative value of the energy storage device from the first time point to the second time point. In a lithium ion battery, a solid electrolyte interface layer (SEI layer) is generated at an interface between an electrode and an electrolyte solution by charging and discharging or standing, and the SOH decreases as the SEI layer grows. Based on the hypothesis that the growth of the SEI layer depends on the SOC, the present inventors have proposed to acquire a SOC representative value that affects a decrease in the SOH of the energy storage device and use the representative value for AI learning. The SOC representative value can be said to be information that abstracts the detailed behavior of the energy storage device in operation and includes, for example, the SOC average, the total SOC variation amount, and the SOC variation range.

The processing unit 23 has a function as a SOH acquisition unit and acquires a SOH of the energy storage device. Sensor information (e.g., current, voltage, and temperature) can be collected from the energy storage device. The SOH can be estimated by a known method based on the sensor information. Alternatively, the SOH may be estimated using a method described in Japanese Patent Application No. 2017-065532 (its entire contents are incorporated herein by reference).

More specifically, the processing unit 23 acquires the SOH of the energy storage device at the first time point and the SOH at the second time point after the first time point. The energy storage device may be, for example, an energy storage device operating in a mobile body or a facility. Sensor information (e.g., current, voltage, and temperature) can be collected from the energy storage device by using a monitoring apparatus or the like. The SOH can be estimated by a known method based on the sensor information. Alternatively, the SOH may be estimated using a method described in Japanese Patent Application No. 2017-065532 (its entire contents are incorporated herein by reference). The period between the first time point and the second time point can be appropriately set and may be, for example, one month or three months. When the sensor information has periodicity, the period between the first time point and the second time point may be divided by the cycle of the sensor information. At that time, an interpolation value at the first and second time points may be used for the SOH.

The learning processing unit 28 has a function as a relearning processing unit and uses the acquired SOC representative value and the acquired SOH as learning data to cause the learning model 27 to relearn.

More specifically, the learning processing unit 28 causes the learning-completed learning model 27 to relearn based on learning data with the SOH at the first time point and the representative value as input data and with the SOH at the second time point as output data. For example, the SOH at the first time point is represented by SOH(N), and the SOH at the second time point is represented by SOH(N+1). The learning model relearns that the SOH at the first time point is SOH(N), and the SOH at the second time point is SOH(N+1) in accordance with a SOC representative value of the energy storage device from the first time point to the second time point.

Such learning data includes the SOH at the first time point, the SOH at the second time point, and the SOC representative value between the first time point and the second time point. The SOC representative value can be said to be a statistic obtained by abstracting or processing information for causing the learning-completed learning model 27 to relearn. Thus, the learning-completed learning model can be relearned with a relatively small amount of information, and a large amount of data of the energy storage device is not required.

When a SOH at a certain time point (e.g., at present) and a SOC representative value from the time point to a prediction target point are input to a learning-completed or relearning-completed learning model 27, a SOH at the prediction target point can be estimated. Thereby, the degradation of the energy storage device can be estimated using the AI.

Fig. 28 is a schematic diagram showing an example of the relationship between the learning data set of the learning model 27 and the estimation accuracy. In Fig. 28, the vertical axis indicates the estimation accuracy (percentage of correct answers) of the learning model 27, and the horizontal axis indicates a learning data set (amount of data required for learning). A curve indicated by symbol R' represents a case of learning based only on a measured value (e.g., market data). As a curve indicated by symbol R' shows, the SOC representative value or the SOH obtained by collecting sensor information, for example, tends to require a large amount of data for learning in order to enhance the estimation accuracy (percentage of correct answers) of the learning model 27 when the pattern of transition becomes complicated and learning model 27 not having learned is caused to learn using these pieces of data as data for learning.

A curve indicated by symbol Sa shows a case where data of the degradation simulator 50 is used as data for learning and is learned. When representative values of SOCs of various patterns are input to the degradation simulator 50, the degradation simulator 50 outputs a degradation value (i.e., SOH) with high accuracy with respect to the input SOC representative values, thereby making it possible to easily generate data for learning of the learning model 27 and easily generate the estimation accuracy (percentage of correct answers) of the learning model 27. As a curve indicated by symbol Sa shows, by using the degradation simulator in advance, the learning data can be obtained relatively easily, and the estimation accuracy of the learning model not having learned can be enhanced. However, as shown by a curve of symbol Sb, in a case where a parameter of the degradation simulator 50 is determined, there is a tendency that a large amount of data is hardly reflected, and the estimation accuracy is not easily improved in proportion to the amount of data.

A curve indicated by symbol R shows a case where relearning is performed based on the measured value after learning has been performed using the estimated value of the degradation simulator 50. As the curve indicated by symbol R shows, the accuracy of the learning model 27 can be further enhanced even without a large amount of data for learning, and the accuracy of the degradation estimation of the energy storage device can be enhanced.

As described above, the learning model 27 has been caused to learn using as learning data a SOC representative value to be input to a degradation simulator 50 and the SOH output by the degradation simulator 50 when the SOC representative value is input to the degradation simulator 50. The learning model 27 has further caused to relearn using the SOC representative value of the energy storage device and the SOH of the energy storage device as learning data.

In the learning of the learning model 27, by using the degradation simulator 50 in advance, the learning data can be obtained relatively easily, and the estimation accuracy of the learning model 27 not having learned can be enhanced. Therefore, by relearning processing, the accuracy of the learning model 27 can be further enhanced even without a large amount of data for learning, and the accuracy of the degradation estimation of the energy storage device can be enhanced.

The server apparatus 2 acquires the SOH of the energy storage device at the first time point. The server apparatus 2 acquires a SOC representative value of the energy storage device from the first time point to the second time point. The server apparatus 2 can estimate the SOH at the second time point by inputting the SOH at the first time point and the acquired SOC representative value to the learning model 27.

The server apparatus 2 can estimate a SOH at the prediction target point by inputting a SOH at a certain time point (e.g., at present) and a SOC representative value from the time point to a prediction target point to the learning-completed or relearning-completed learning model 27. Thereby, the degradation of the energy storage device can be estimated using the AI.

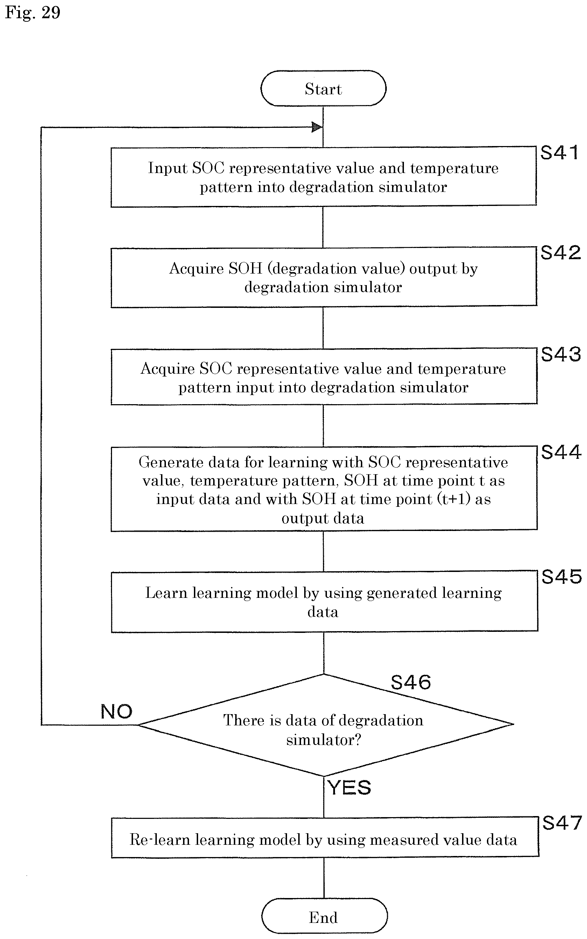

Fig. 29 is a flowchart showing an example of a processing procedure of the processing unit 23 in the learning mode according to the third embodiment. The processing unit 23 inputs a SOC representative value and a temperature pattern to the degradation simulator (S41), acquires a SOH (degradation value) output from the degradation simulator (S42), and acquires the SOC representative value and the temperature pattern input to the degradation simulator 50 (S43). Note that the processing in step S41 is not performed by the processing unit 23 but can be performed by another apparatus in advance.

The processing unit 23 generates data for learning with the SOC representative value, the temperature pattern, and the SOH at time point t as input data and with the SOH at time point t+1 as output data (S44) and causes the learning model 27 to learn using the generated data for learning (S45).

The processing unit 23 determines whether or not there is data in the degradation simulator 50 (S46), and when there is data (YES in step S46), the processing unit 23 continues the processing from step S41 on and after. When there is no data (NO in S46), the processing unit 23 causes the learning model 27 to relearn by using measured value data (S47) and ends the processing. The processing in step S47 may be the same as the processing illustrated in Fig. 21.

In the embodiment described above, the server apparatus 2 has included the learning model 27 and the learning processing unit 28, but the present invention is not limited thereto. For example, the learning model 27 and the learning processing unit 28 may be provided in one or more other servers. The degradation estimation apparatus is not limited to the server apparatus 2. For example, an apparatus such as a life estimation simulator may be used. The degradation simulator 50 can be incorporated into the server apparatus 2 and can also be configured as a separate apparatus from the server apparatus 2.

The control unit 20 and the processing unit 23 of the present embodiment can also be achieved using a general-purpose computer provided with a CPU (processor), a GPU, a RAM (memory), and the like. That is, the control unit 20 and the processing unit 23 can be achieved on a computer by loading a computer program that determines the procedure of each processing, as shown in Figs. 21, 22, and 29, into the RAM (memory) provided in the computer and executing the computer program with the CPU (processor). The computer program may be recorded on a recording medium and distributed. The learning model 27 caused to learn by the server apparatus 2 and the computer program based on the learning model may be distributed to and installed into the target apparatuses P, U, D, M for remote monitoring, the terminal apparatus via the network N and the communication device 1.

In the embodiment described above, for example, in order to avoid overlearning, in an initial stage of the learning, the learning model 27 may be caused to learn using the representative value and may then be caused to learn using the measured value. In addition, amounts of data of the representative value and the measured value may be appropriately changed in accordance with a learning stage, or a ratio of both may be changed. Further, the data for learning can be divided into so-called training data and test data, the learning model 27 is first caused to learn using the training data, and then the learning model 27 can be evaluated using the test data.

Embodiments are exemplary in all respects and are not restrictive. The scope of the present invention is defined by the claims.

### DESCRIPTION OF REFERENCE SIGNS

2: server apparatus
20: control unit
21: communications unit
22: storage unit
23: processing unit
24: SOC estimation unit
25: SOC representative value acquisition unit
26: learning data generation unit
27: learning model
28: learning processing unit
29: input data generation unit
50: degradation simulator

## Claims

1. A degradation estimation apparatus for estimating degradation of an energy storage device, the apparatus comprising:
a state of health, SOH, acquisition unit (23) that is configured to acquire a SOH of an energy storage device at a first time point and a SOH at a second time point after the first time point;
a SOC estimation unit (24) that is configured to estimate a SOC transition of the energy storage device from the first time point to the second time point,
a representative value acquisition unit (25) that is configured to acquire a representative value of a state of charge, SOC, of the energy storage device from the first time point to the second time point; wherein the representative value acquisition unit (25) is configured to acquire at least any one of a total SOC variation amount, a SOC variation range from the first time point to the second time point based on the SOC transition, and a SOC transition pattern and
a learning processing unit (28) that is configured to cause a learning model (27) to learn based on learning data with the SOH at the first time point and the representative value as input data and with the SOH at the second time point as output data.

2. The degradation estimation apparatus according to claim 1, comprising a temperature acquisition unit (23) that is configured to acquire a temperature transition of the energy storage device from the first time point to the second time point, wherein the learning processing unit is configured to cause a learning model to learn based on learning data with the temperature transition as additional input data.

3. The degradation estimation apparatus according to any one of claims 1 to 2, wherein the temperature acquisition unit is configured to acquire a temperature representative value of the energy storage device from the first time point to the second time point, and the learning processing unit is configured to cause a learning model to learn based on learning data with the temperature representative value as additional input data.

4. The degradation estimation apparatus according to any one of claims 1 to 3, wherein the learning processing unit is configured to cause a learning model to learn based on learning data with an elapsed period from a point of manufacturing the energy storage device to the first time point as additional input data.

5. The degradation estimation apparatus according to any one of claims 1 to 4, wherein the learning processing unit is configured to cause a learning model to learn based on learning data with a cycle number of charge and discharge from the point of manufacturing the energy storage device to the first time point as additional input data.

6. The degradation estimation apparatus according to any one of claims 1 to 5, wherein the learning processing unit is configured to provide a plurality of learning periods from the first time point to the second time point over a use period of the energy storage device to cause a learning model to learn based on learning data.

7. The degradation estimation apparatus according to any one of claims 1 to 6, wherein degradation of the energy storage device is estimated using a learning-completed learning model caused to learn by the learning processing unit.

8. The degradation estimation apparatus according to claim 1, wherein
a learning-completed learning model has the SOH at the first time point and the representative value as input data and estimates the SOH at the second time point.

9. A degradation estimation method for estimating degradation of an energy storage device, the method comprising:
acquiring a state of health, SOH, of an energy storage device at a first time point and a SOH at a second time point after the first time point;
acquiring a representative value of a state of charge, SOC, of the energy storage device from the first time point to the second time point; and
causing a learning model to learn based on learning data with the SOH at the first time point and the representative value as input data and with the SOH at the second time point as output data, and
estimating a SOC transition of the energy storage device from the first time point to the second time point, wherein the representative value acquisition unit acquires at least any one of a total SOC variation amount, a SOC variation range from the first time point to the second time point based on the SOC transition, and a SOC transition pattern.

## Patentansprüche

1. Vorrichtung für Schätzung von Alterung einer Energiespeichereinrichtung, wobei die Vorrichtung umfasst:
eine Einheit (23) für Erfassung eines SOH-Wertes, die so konfiguriert ist, dass sie einen SOH-Wert einer Energiespeichereinrichtung zu einem ersten Zeitpunkt und einen SOH-Wert zu einem zweiten Zeitpunkt nach dem ersten Zeitpunkt erfasst;
eine Einheit (24) für Schätzung eines SOC-Wertes, die so konfiguriert ist, dass sie einen SOC-Übergang der Energiespeichereinrichtung von dem ersten Zeitpunkt zu dem zweiten Zeitpunkt schätzt,
eine Einheit (25) für Erfassung eines typischen Wertes, die so konfiguriert ist, dass sie einen typischen Wert eines Ladezustandes (SOC) der Energiespeichereinrichtung von dem ersten Zeitpunkt bis zu dem zweiten Zeitpunkt erfasst; wobei die Einheit (25) für Erfassung eines typischen Wertes so konfiguriert ist, dass sie einen Gesamtbetrag von Änderung des Ladezustandes, einen Bereich von Änderung des Ladezustandes von dem ersten Zeitpunkt bis zu dem zweiten Zeitpunkt auf Basis des SOC-Übergangs oder/und ein Muster des SOC-Übergangs erfasst, sowie
eine Einheit (28) für Lern-Verarbeitung, die so konfiguriert ist, dass sie ein Lernmodell (27) veranlasst, auf Basis von Lerndaten mit dem SOH-Wert zu dem ersten Zeitpunkt und dem typischen Wert als Eingangsdaten sowie mit dem SOH-WERT zu dem zweiten Zeitpunkt als Ausgangs-Datenelement zu lernen.

2. Vorrichtung für Schätzung von Alterung nach Anspruch 1, die eine Einheit (23) für Temperaturerfassung umfasst, die so konfiguriert ist, dass sie einen Temperaturübergang der Energiespeichereinrichtung von dem ersten Zeitpunkt bis zu dem zweiten Zeitpunkt erfasst, wobei die Einheit für Lern-Verarbeitung so konfiguriert ist, dass sie ein Lernmodell veranlasst, auf Basis von Lerndaten mit dem Temperaturübergang als zusätzlichem Eingangs-Datenelement zu lernen.

3. Vorrichtung für Schätzung von Alterung nach einem der Ansprüche 1 bis 2, wobei die Einheit für Temperaturerfassung so konfiguriert ist, dass sie einen typischen Temperaturwert der Energiespeichereinrichtung von dem ersten Zeitpunkt bis zu dem zweiten Zeitpunkt erfasst, und die Einheit für Lern-Verarbeitung so konfiguriert ist, dass sie ein Lernmodell veranlasst, auf Basis von Lerndaten mit dem typischen Temperaturwert als zusätzlichem Eingangs-Datenelement zu lernen.

4. Vorrichtung für Schätzung von Alterung nach einem der Ansprüche 1 bis 3, wobei die Einheit für Lern-Verarbeitung so konfiguriert ist, dass sie ein Lernmodell veranlasst, auf Basis von Lerndaten mit einer verstrichenen Zeitspanne von einem Herstellungs-Zeitpunkt der Energiespeichereinrichtung bis zu dem ersten Zeitpunkt als zusätzlichem Eingangs-Datenelement zu lernen.

5. Vorrichtung für Schätzung von Alterung nach einem der Ansprüche 1 bis 4, wobei die Einheit für Lern-Verarbeitung so konfiguriert ist, dass sie ein Lernmodell veranlasst, auf Basis von Lerndaten mit einer Anzahl von Lade- und Entlade-Zyklen von dem Herstellungs-Zeitpunkt der Energiespeichereinrichtung bis zu dem ersten Zeitpunkt als zusätzlichem Eingabe-Datenelement zu lernen.

6. Vorrichtung für Schätzung von Alterung nach einem der Ansprüche 1 bis 5, wobei die Einheit für Lern-Verarbeitung so konfiguriert ist, dass sie eine Vielzahl von Lernperioden von dem ersten Zeitpunkt bis zu dem zweiten Zeitpunkt über einen Nutzungszeitraum der Energiespeichereinrichtung schafft, in denen ein Lernmodell veranlasst wird, auf Basis von Lerndaten zu lernen.

7. Vorrichtung für Schätzung von Alterung nach einem der Ansprüche 1 bis 6, wobei Alterung der Energiespeichereinrichtung unter Verwendung eines Lernmodells mit abgeschlossenem Lernvorgang geschätzt wird, dessen Lernen von der Einheit für Lern-Verarbeitung zum Lernen veranlasst wird.

8. Vorrichtung für Schätzung von Alterung nach Anspruch 1, wobei
ein Lernmodell mit abgeschlossenem Lernvorgang den SOH-Wert zu dem ersten Zeitpunkt und den typischen Wert als Eingangsdaten aufweist und den SOH-Wert zu dem zweiten Zeitpunkt schätzt.

9. Verfahren für Schätzung von Alterung einer Energiespeichereinrichtung, wobei das Verfahren umfasst:
Erfassen eines SOH-Wertes einer Energiespeichereinrichtung zu einem ersten Zeitpunkt und eines SOH-Wertes zu einem zweiten Zeitpunkt nach dem ersten Zeitpunkt;
Erfassen eines typischen Wertes eines Ladezustandes (SOC) der Energiespeichereinrichtung von dem ersten Zeitpunkt bis zu dem zweiten Zeitpunkt; und
Veranlassen, dass ein Lernmodell auf Basis von Lerndaten mit dem SOH-WERT zu dem ersten Zeitpunkt und dem typischen Wert als Eingangsdaten sowie mit dem SOH-WERT zu dem zweiten Zeitpunkt als Ausgangs-Datenelement lernt, und
Schätzen eines SOC-Übergangs der Energiespeichereinrichtung von dem ersten Zeitpunkt zu dem zweiten Zeitpunkt, wobei die Einheit für Erfassung eines typischen Wertes einen Gesamtbetrag von Änderung des Ladezustandes, einen Bereich von Änderung des Ladezustandes von dem ersten Zeitpunkt bis zu dem zweiten Zeitpunkt auf Basis des SOC-Übergangs oder/und ein Muster des SOC-Übergangs erfasst.

## Revendications

1. Appareil d'estimation de dégradation destiné à évaluer la dégradation d'un dispositif de stockage de l'énergie, l'appareil comprenant :
une unité d'acquisition d'état de santé, SOH, (23) qui est configurée pour acquérir un état SOH d'un dispositif de stockage de l'énergie à un premier instant et un état SOH à un second instant situé après le premier instant,
une unité d'estimation d'état de charge, SOC, (24) qui est configurée pour évaluer une transition d'état SOC du dispositif de stockage de l'énergie depuis le premier instant jusqu'au second instant,
une unité d'acquisition de valeur représentative (25) qui est configurée pour acquérir une valeur représentative de l'état de charge, SOC, du dispositif de stockage de l'énergie depuis le premier instant jusqu'au second instant, l'unité d'acquisition de valeur représentative (25) étant configurée pour acquérir au moins l'une d'une valeur totale de variation d'état SOC, d'une plage de variation d'état SOC depuis le premier instant jusqu'au second instant, sur la base de la transition d'état SOC, et d'une séquence de transition d'états SOC, et
une unité de traitement d'apprentissage (28) qui est configurée pour amener un modèle d'apprentissage (27) à apprendre sur la base de données d'apprentissage avec l'état SOH au premier instant et la valeur représentative en tant que données d'entrée et avec l'état SOH au second instant en tant que données de sortie.

2. Appareil d'estimation de dégradation selon la revendication 1, comprenant une unité d'acquisition de température (23) qui est configurée pour acquérir une transition de température du dispositif de stockage de l'énergie depuis le premier instant jusqu'au second instant, l'unité de traitement d'apprentissage étant configurée pour amener un modèle d'apprentissage à apprendre sur la base des données d'apprentissage, la transition de température étant une donnée supplémentaire d'entrée.

3. Appareil d'estimation de dégradation selon l'une quelconque des revendications 1 à 2, dans lequel l'unité d'acquisition de température est configurée pour acquérir une valeur représentative de la température du dispositif de stockage de l'énergie depuis le premier instant jusqu'au second instant, et l'unité de traitement d'apprentissage est configurée pour amener un modèle d'apprentissage à apprendre sur la base de données d'apprentissage, la valeur représentative de température étant une donnée supplémentaire d'entrée.

4. Appareil d'estimation de dégradation selon l'une quelconque des revendications 1 à 3, dans lequel l'unité de traitement d'apprentissage est configurée pour amener un modèle d'apprentissage à apprendre sur la base de données d'apprentissage, la période écoulée depuis l'instant de fabrication du dispositif de stockage de l'énergie jusqu'au premier instant étant une donnée supplémentaire d'entrée.

5. Appareil d'estimation de dégradation selon l'une quelconque des revendications 1 à 4, dans lequel l'unité de traitement d'apprentissage est configurée pour amener un modèle d'apprentissage à apprendre sur la base de données d'apprentissage, le nombre de cycles de charge et de décharge depuis l'instant de fabrication du dispositif de stockage de l'énergie jusqu'au premier instant étant une donnée supplémentaire d'entrée.

6. Appareil d'estimation de dégradation selon l'une quelconque des revendications 1 à 5, dans lequel l'unité de traitement d'apprentissage est configurée pour fournir une pluralité de périodes d'apprentissage depuis le premier instant jusqu'au second instant sur la période d'utilisation du dispositif de stockage de l'énergie afin d'amener le modèle d'apprentissage à apprendre sur la base de données d'apprentissage.

7. Appareil d'estimation de dégradation selon l'une quelconque des revendications 1 à 6, dans lequel la dégradation du dispositif de stockage de l'énergie est évaluée en utilisant un modèle d'apprentissage à apprentissage achevé qui est amené à assimiler grâce à l'unité de traitement d'apprentissage.

8. Appareil d'estimation de dégradation selon la revendication 1, dans lequel :
le modèle d'apprentissage à apprentissage achevé comporte comme données d'entrée l'état SOH au premier instant et la valeur représentative, et il évalue l'état SOH au second instant.

9. Procédé d'estimation de dégradation consistant à évaluer la dégradation d'un dispositif de stockage de l'énergie, le procédé comprenant :
l'acquisition d'un état SOH d'un dispositif de stockage de l'énergie à un premier instant et d'un état SOH à un second instant situé après le premier instant,
l'acquisition d'une valeur représentative de l'état de charge, SOC, du dispositif de stockage de l'énergie depuis le premier instant jusqu'au second instant, et
l'action consistant à amener un modèle d'apprentissage à apprendre sur la base de données d'apprentissage comportant l'état SOH au premier instant et la valeur représentative comme données d'entrée, et comportant l'état SOH au second instant comme données de sortie, et
l'estimation d'une transition d'état SOC du dispositif de stockage de l'énergie depuis le premier instant jusqu'au second instant, l'unité d'acquisition de valeur représentative acquérant au moins l'une d'une valeur totale de variation d'état SOC, d'une plage de variation d'état SOC depuis le premier instant jusqu'au second instant, sur la base de la transition d'état SOC, et d'une séquence de transition d'états SOC.
